(19) Europäisches Patentamt
European Patent Office
Office européen des brevets

(11) **EP 2 955 733 A1**

(12) **EUROPEAN PATENT APPLICATION**
published in accordance with Art. 153(4) EPC

(43) Date of publication:
**16.12.2015 Bulletin 2015/51**

(51) Int Cl.:
**H01G 4/33** (2006.01)     **C23C 14/56** (2006.01)

(21) Application number: **14748896.9**

(22) Date of filing: **06.02.2014**

(86) International application number:
**PCT/JP2014/052748**

(87) International publication number:
**WO 2014/123182 (14.08.2014 Gazette 2014/33)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **06.02.2013   JP 2013021414**

(71) Applicant: **Rohm Co., Ltd.**
**Kyoto-shi, Kyoto 615-8585 (JP)**

(72) Inventors:
• **TSURUMI, Naoaki**
**Kyoto-shi**
**Kyoto 615-8585 (JP)**
• **KANETAKE, Yasuo**
**Kyoto-shi**
**Kyoto 615-8585 (JP)**

(74) Representative: **Witte, Weller & Partner**
**Patentanwälte mbB**
**Postfach 10 54 62**
**70047 Stuttgart (DE)**

(54) **MULTI-LAYER STRUCTURE, CAPACITOR ELEMENT, AND METHOD FOR MANUFACTURING SAME**

(57)     The multilayered structure includes: a substrate (10); a buffer layer (12) disposed on the substrate (10); a lower electrode (14) disposed on the buffer layer (12), and a dielectric layer (16) disposed on the lower electrode (14), the dielectric layer composed of nitrides. Furthermore, the capacitor element includes: an upper electrode (18) disposed on the dielectric layer (16), a first terminal electrode connected to the lower electrode (14), and a second terminal electrode connected to the upper electrode (18). There is provided a capacitor element excellent in high-temperature stability, and a fabrication method of such a capacitor element.

FIG. 1

**Description**

**TECHNICAL FIELD**

The embodiment described herein relates to a multilayered structure, a capacitor element, and a fabrication method of the capacitor element. The embodiment relates to in particular a multilayered structure, a capacitor element, and a fabrication method of the capacitor element, each excellent in high-temperature stability.

**BACKGROUND ART**

Laminated ceramic capacitors, electrolytic capacitors, film capacitors, etc. are known, as conventional capacitor elements.

Moreover, there has been disclosed a capacitor element having a laminated structure composed of $Al/SiO_x/BN/SiO_x/Al$ on a silicon (Si) substrate.

Moreover, there has been also disclosed a capacitor element using AlN as a dielectric layer (Refer to Patent Literature 3, for example.).

Patent Literature 1: U.S. Patent No. 6,570,753
Patent Literature 2: U.S. Patent No. 6,939,775
Patent Literature 3: Japanese Patent Application Laid-Open Publication No. H06-267783

**SUMMARY OF INVENTION**

**Technical Problem**

Since ferroelectrics, e.g. a barium titanate ($BaTiO_3$), are used for laminated ceramic capacitors, ferroelectric materials are phase-transited thereto at the time of high temperature operation. Accordingly, a value of capacitance is reduced at the time of the high temperature operation. On the other hand, laminated ceramic capacitors to which paraelectrics materials are applied is impervious to high temperatures, but the capacitance values thereof are relatively small. Moreover, since oxide substances are used as materials, oxygen defects occurs, and thereby reliability easily reduced.

Electrolytic capacitors contain high temperature sensitive materials, and therefore there is a problem of drying up of electrolysis solutions.

Film capacitors contain organic substances as materials, and therefore are heat-sensitive capacitors.

The object of the present invention is to provide a multilayered structure, a capacitor element, and a fabrication method of the capacitor element, each excellent in high-temperature stability.

**Solution to Problem**

According to one aspect of the present invention, there is provided a multilayered structure comprising: a substrate; a buffer layer disposed on the substrate; a lower electrode disposed on the buffer layer; and a dielectric layer disposed on the lower electrode, the dielectric layer composed of nitrides.

According to another aspect of the present invention, there is provided a capacitor element comprising: a multilayered structure comprising a substrate, a buffer layer disposed on the substrate, a lower electrode disposed on the buffer layer, a dielectric layer disposed on the lower electrode, the dielectric layer composed of nitrides, and an upper electrode disposed on the dielectric layer; a first terminal electrode connected to the lower electrode; and a second terminal electrode connected to the upper electrode.

According to still another aspect of the present invention, there is provided a fabrication method of a capacitor element, the method comprising: pre-processing a substrate; forming a buffer layer on the substrate; forming a lower electrode on the buffer layer; forming a dielectric layer on the lower electrode, the dielectric layer composed of nitrides; and forming an upper electrode on the dielectric layer.

According to still another aspect of the embodiment, there is provided a cutting tool comprising: a multilayered structure comprising a substrate, a buffer layer disposed on the substrate, a lower electrode disposed on the buffer layer, and a dielectric layer disposed on the lower electrode, the dielectric layer composed of nitrides.

According to still another aspect of the present invention, there is provided an inverter equipment comprising: a capacitor element comprising a multilayered structure, a first terminal electrode, and a second terminal electrode, the multilayered structure comprising a substrate, a buffer layer disposed on the substrate, a lower electrode disposed on the buffer layer, a dielectric layer disposed on the lower electrode, the dielectric layer composed of nitrides, and an upper electrode disposed on the dielectric layer, the first terminal electrode connected to the lower electrode, the second terminal electrode connected to the upper electrode, wherein the capacitor element is mounted on the inverter equipment.

According to still another aspect of the present invention, there is provided a capacitor fabricating apparatus comprising: a material supply roller; a material winding roller; a plurality of tension rollers; a material transferred via the tension roller between the material supply roller and the material winding roller; and a vacuum chamber configured to supply a target material by sputtering from film-forming material supplying target in a film formation area on the material, wherein the sputtering process of film formation for a plurality of layers in the film formation area can be implemented with the roll-to-roll process in the vacuum chamber.

**Advantageous Effects of Invention**

According to the present invention, there can be provided the multilayered structure, the capacitor element, and the fabrication method of the capacitor element, each excellent in high-temperature stability.

**BRIEF DESCRIPTION OF THE DRAWINGS**

[Fig. 1] A schematic cross-sectional structure diagram showing a multilayered structure and a capacitor element according to an embodiment.

[Fig. 2] A schematic cross-sectional structure diagram showing a multilayered structure and a capacitor element according to a modified example of the embodiment.

[Fig. 3] A schematic bird's-eye view structure diagram showing the capacitor element according to the embodiment and the modified example thereof.

[Fig. 4] An example of a Transmission Electron Microscope (TEM) photograph of a dielectric layer, in the multilayered structure and the capacitor element according to the modified example of the embodiment.

[Fig. 5] An example of a TEM photograph of a buffer layer, in the multilayered structure and the capacitor element according to the modified example of the embodiment.

[Fig. 6] An example of an Atomic Force Microscope (AFM) photograph on a surface of the dielectric layer in a sample formed without forming a buffer layer, in a structure of the multilayered structure and the capacitor element according to the modified example of the embodiment.

[Fig. 7] An example of an AFM photograph on the surface of the dielectric layer in a sample formed with forming the buffer layer, in the structure of the multilayered structure and the capacitor element according to the modified example of the embodiment.

[Fig. 8] A diagram showing a relationship between current density (A/mm$^2$) and an electric field (v/$\mu$m) (an example of A: without buffer layer, B1: IrTa used for buffer layer, and B2: TiAlN is used for buffer layer) in which an upper electrode is a positive electrode (plus) and a lower electrode is a negative electrode (minus), in the structure of the multilayered structure and the capacitor element according to the modified example of the embodiment.

[Fig. 9] An example of a Scanning Electron Microscope (SEM) photograph of a surface of Al foil in the case of applying the Al foil as a metallic substrate, in the structure of the multilayered structure and the capacitor element according to the embodiment.

[Fig. 10] (a) An example of a circuit configuration of the capacitor element, which is an example of a single element, (b) an example of parallel connection configuration, according to the embodiment, (c) an example of a series parallel connection configuration, according to the embodiment.

[Fig. 11] An example of a prototype photograph of the element capacitor formed on a metallic foil (electrode size: 65 mm × 20 mm), in the capacitor element according to the embodiment.

[Fig. 12] An example of frequency characteristics of a capacitance C of the capacitor element formed on the metallic foil, in the capacitor element according to the embodiment.

[Fig. 13] An example of temperature characteristics of the capacitance C and dielectric loss $D_f$ of the capacitor element formed on the metallic foil, in the capacitor element according to the embodiment.

[Fig. 14] A schematic front surface pattern configuration diagram of element capacitors formed on the metallic foil, in the capacitor element according to the embodiment.

[Fig. 15] An example of an external photograph of a device formed of the capacitor element with a laminating method, according to the embodiment.

[Fig. 16] A schematic bird's-eye view structure diagram in an inside of a package of the capacitor element shown in Fig. 15.

[Fig. 17] (a) A schematic diagram for explaining an aspect that two sheets of the element capacitors are layered via a separator, and (b) a schematic cross-sectional structure diagram showing n layers of the element capacitors laminated via the separator, in the capacitor element according to the embodiment.

[Fig. 18] (a) A process chart of pre-processing of a substrate, (b) a process chart of forming a buffer layer on the substrate, (c) a process chart of forming a lower electrode on the buffer layer, and (d) a process chart of forming a dielectric layer on the lower electrode, in the fabrication method of the capacitor element according to the embodiment.

[Fig. 19] (a) A process chart of forming an upper electrode on the dielectric layer, (b) a process chart of forming an Ni layer on the upper electrode, and an Ag layer on the Ni layer one by one, and (c) a process chart of forming an Ni layer on the substrate, and an Ag layer on the Ni layer one by one, in the fabrication method of the capacitor element according to the embodiment.

[Fig. 20] (a) An example of an outside surface photograph of the capacitor element according to the embodiment, and (b) a schematic front surface pattern configuration diagram of the capacitor element according to the embodiment.

[Fig. 21] An example of temperature characteristics of the rate of capacitance change ΔC (%), in the capacitor element according to the embodiment.

[Fig. 22] (a) A front surface pattern configuration diagram of a first element capacitor, (b) a back surface pattern configuration diagram of a second element capacitor, and (c) a front surface pattern configuration diagram before winding up the laminated first element capacitor and second element capacitor onto a core rod, in the capacitor element according to the embodiment (example of the device made by the roll method).

[Fig. 23] (a) A front surface pattern configuration diagram after winding up the laminated first element capacitor and second element capacitor onto a core rod, in the capacitor element according to the embodiment (example of the device made by the roll method) (b) an example of an external photograph of a wound state of the capacitor element, and (c) an example of an external photograph in a state of the capacitor element according to the embodiment being connected to external electrode terminals and housed in a case.

[Fig. 24] A schematic configuration diagram showing an equipment configuration of a fabricating apparatus applicable to the fabrication method of the capacitor element according to the embodiment which can be mass-produced with a roll-to-roll method by applying the same chamber to a sputtering process.

[Fig. 25] A schematic circuit configuration diagram of a three-phase alternating current (AC) inverter equipment configured so that six power module semiconductor devices are arranged and the capacitor elements Cu, Cv, Cw according to the embodiment are mounted thereon.

[Fig. 26] A schematic circuit representative diagram of a 1-in-1 module, which is a power module semiconductor device applicable to the three-phase AC inverter equipment shown in Fig. 25.

[Fig. 27] A detail circuit representative diagram showing the 1-in-1 module.

[Fig. 28] A bird's-eye view showing a power module semiconductor device having straight wiring structure, which is a power module semiconductor device applicable to the three-phase AC inverter equipment shown in Fig. 25.

[Fig. 29] A schematic plane configuration diagram showing the power module semiconductor device having straight wiring structure.

[Fig. 30] A diagram showing an example of arranging a control substrate and a power source substrate at a upper part, in a schematic plane configuration diagram also including connection wiring (bus bar) electrodes (GNDL, POWL) between each power terminal of the three-phase AC inverter, wherein the three-phase AC inverter equipment is configured so that six power module semiconductor devices are arranged and the capacitor elements Cu, Cv, Cw according to the embodiment are mounted thereon.

[Fig. 31] A schematic cross-sectional structure diagram taken in the line I-I of Fig. 30.

[Fig. 32] A schematic bird's-eye view showing the three-phase AC inverter configured to arrange six power module semiconductor devices, in which the capacitor elements Cu, Cv, Cw according to the embodiment are mounted thereon, and the control substrate and the power source substrate are arranged thereon.

[Fig. 33] An example of a circuit configuration in which snubber capacitors are connected to between a power supply terminal PL and a ground terminal (earth terminal) NL, in the schematic circuit configuration of the three-phase AC inverter configured so that six power module semiconductor devices are arranged and the capacitor elements Cu, Cv, Cw according to the embodiment are mounted thereon.

[Fig. 34] A schematic circuit block configuration diagram for explaining a three-phase motor drive of the three-phase AC inverter equipment configured so that six power module semiconductor devices are arranged and the capacitor elements Cu, Cv, Cw according to the embodiment are mounted thereon.

[Fig. 35] A circuit configuration diagram showing a U-phase unit in the three-phase AC inverter equipment which mounted capacitor element configured so that six power module semiconductor devices are arranged and the capacitor elements Cu, Cv, Cw according to the embodiment are mounted thereon.

[Fig. 36] (a) An example of a switching voltage waveform in the state where the capacitor element Cu according to the embodiment is removed from the circuit shown in Fig. 35, and (b) an example of a switching voltage waveform in the state where the capacitor element Cu according to the embodiment is applied thereto.

[Fig. 37] (a) A schematic bird's-eye view of a tap screw which is a cutting tool to which a multilayered structure according to the embodiment is applied, and (b) a schematic cross-sectional structure diagram of the multilayered structure applicable to the tap screw shown in Fig. 37(a).

**DESCRIPTION OF EMBODIMENTS**

Next, the embodiment of the present invention will be described with reference to drawings. In the description of the following drawings, the identical or similar reference numeral is attached to the identical or similar part. However, it should be known about that the drawings are schematic and the relation between thickness and the plane size and the ratio of the thickness of each layer differs from an actual thing. Therefore, detailed thickness and size should be determined in consideration of the following explanation. Of course, the part from which the relation and ratio of a mutual size differ also in mutually drawings is included.

Moreover, the embodiment shown hereinafter exemplifies the apparatus and method for materializing the technical idea of the present invention; and the embodiment of the present invention does not specify the material, shape, structure, placement, etc. of each component part as the following. The embodiment of the present invention may be changed without departing from the spirit or scope of claims.

**(Multilayered structure)**

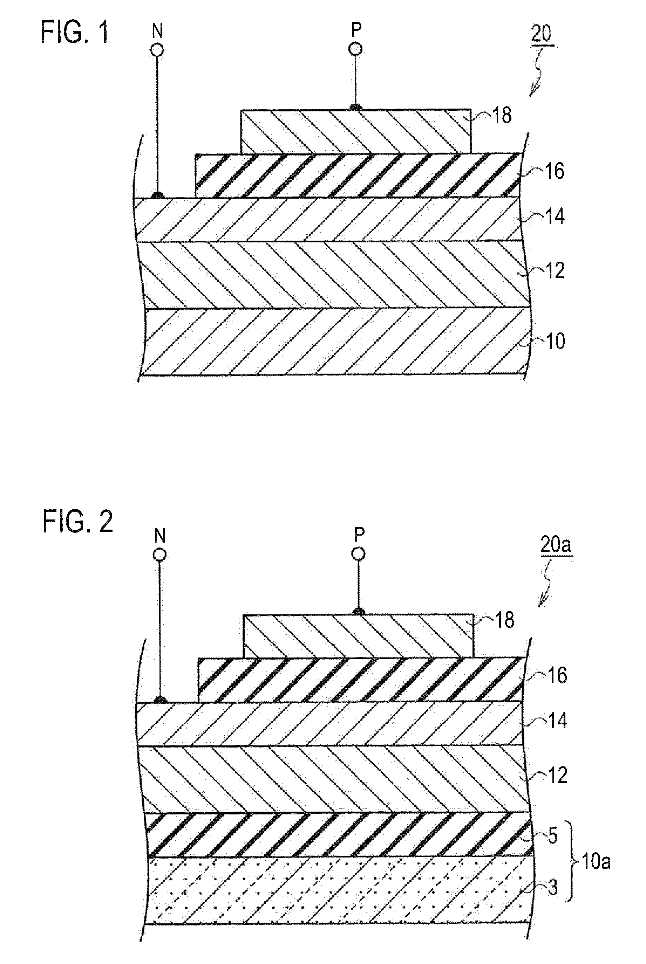

As shown in Fig. 1, a multilayered structure according to the embodiment including: a substrate 10; a buffer layer 12 disposed on the substrate 10; a lower electrode 14 disposed on the buffer layer 12; and a dielectric layer 16 disposed on the lower electrode 14, the dielectric layer 16 composed of nitrides.

In the embodiment, the buffer layer 12 may include TiAlN, IrTa, or CuTa.

Moreover, the dielectric layer 16 may include nitrogen, and may include at least one kind of boron, carbon, aluminum, or silicon.

Moreover, the dielectric layer 16 may include any one of BN, BCN, CN, BAlN, BSiN, AlN or SiN.

Moreover, the dielectric layer 16 include an amorphous layer.

Similarly, the buffer layer 12 may also include an amorphous conductor. There can be continuity between the lower electrode 14 and the metallic substrate 10 by applying the amorphous conductor to the buffer layer 12, and thereby laminated structure can easily be formed.

In the embodiment, as materials applicable to the buffer layer 12, combinations of materials which is amorphous and has electrical conductivity are as follows:

CuTa is applicable to a combination of 3d transition metals + refractory metals.

NiAg, TiAg, NiPt, and NiIr are applicable to combination of a 3d transition metals + noble metals.

IrTa and PtTa are applicable to a combination of noble metals + refractory metals.

TaSi, TaAl, WSi, MoSi, and NbB are applicable to a combination of refractory metals + semimetals.

TiAlN, TiAlB, TiSiB, NiAlN, NiAlB, and NiSiB are applicable to a combination of 3d transition metals + semimetals + nonmetals.

TaSiN and TaAlN are applicable to a combination of refractory metals + semimetals + nonmetals.

Moreover, the substrate 10 may include metallic foil, for example. As the metallic foil, it is preferably that, for example, a melting point is equal to or greater than 600 degrees C, it is easily available foil, long-term stability and high conductivity are satisfactory, and it is preferably non-magnetic substance. Metallic foils having little effect on environment or human body is preferable.

The metallic foil can be formed from any one of or any laminated structure of Ti, Ni, Cu, Mo, Al, Nb, Ta, Ag, Zr, Au, Pt, W, Ir, V, stainless-steel (SUS), 42Alloy, nickel silver, and brass. In the embodiment, the composition of the 42Alloy is Fe: approximately 57% and Ni: approximately 42%. Moreover, the composition of the nickel silver is Cu: approximately 50% to approximately 70%, Ni: approximately 5% to approximately 30%, and Zn: approximately 10% to approximately 30%. Moreover, the composition of the brass is Zn: equal to or greater than approximately 20% in Cu+Zn, for example.

Moreover, it is preferable that the lower electrode 14 can be formed by sputtering, has a high melting point and high electrical conductivity, and is a material excellent in high-temperature stability.

Cr, Mo, Al, Ta, Cu, Ti, Ni, W, or Ag is applicable to materials of the lower electrode 14, as long as it is a single metal. CuTa or TiW is applicable thereto as long as it is an alloy. $Ta_2N$ or TiN is applicable thereto as long as it is nitride. $WSi_2$ or TiSi is applicable thereto as long as it is a silicide. TaB is applicable thereto as long as it is a boride.

Moreover, the multilayered structure may further include an upper electrode 18 disposed on the dielectric layer 16. Moreover, it is preferable that the upper electrode 18 can be formed by sputtering, has a high melting point and high electrical conductivity, and is a material excellent in high-temperature stability, in the same manner as the lower electrode 14.

Cr, Mo, Al, Ta, Cu, Ti, Ni, W, or Ag is applicable to materials of the upper electrode 18, as long as it is a single metal, in the same manner as the lower electrode 14. CuTa or TiW is applicable thereto as long as it is an alloy. $Ta_2N$

or TiN is applicable thereto as long as it is nitride. WSi$_2$ or TiSi is applicable thereto as long as it is a silicide. TaB is applicable thereto as long as it is a boride.

As shown in Fig. 2, a multilayered structure according to a modified example of the embodiment includes: a semiconductor substrate 3; an insulating layer 5 disposed on the semiconductor substrate 3; a buffer layer 12 disposed on the insulating layer 5; a lower electrode 14 disposed on the buffer layer 12; a dielectric layer 16 disposed on the lower electrode 14, the dielectric layer 16 composed of nitrides; and an upper electrode 18 disposed on the dielectric layer 16.

In the embodiment, a silicon substrate can be applied to the semiconductor substrate 3, for example, and a silicon oxide layer can be applied to the insulating layer 5. Moreover, in the multilayered structure according to the modified example of the embodiment, it may be considered that a laminated structure composed of the insulating layer 5/the semiconductor substrate 3 correspond to a monolithic-structured substrate 10a.

A plurality of the above-mentioned multilayered structures may be laminated, in the multilayered structure according to the embodiment and the modified example thereof.

**(Capacitor element)**

As shown in Fig. 1, a capacitor element 20 according to the embodiment includes: a substrate 10; a buffer layer 12 disposed on the substrate 10; a lower electrode 14 disposed on the buffer layer 12; a dielectric layer 16 disposed on the lower electrode 14, the dielectric layer 16 composed of nitrides; and an upper electrode 18 disposed on the dielectric layer 16. In the embodiment, the lower electrode 14 and the upper electrode 18 are configure to form a main electrode of the capacitor element according to the embodiment. More specifically, as shown in Fig. 1, a positive electrode (plus) terminal P is connected to the upper electrode 18, and a negative electrode (minus) terminal N is connected to the lower electrode 14.

As shown in Fig. 2, a capacitor element 20a according to the modified example of the embodiment includes: a semiconductor substrate 3; an insulating layer 5 disposed on the semiconductor substrate 3; a buffer layer 12 disposed on the insulating layer 5; a lower electrode 14 disposed on the buffer layer 12; a dielectric layer 16 disposed on the lower electrode 14, the dielectric layer 16 composed of nitrides; and an upper electrode 18 disposed on the dielectric layer 16. In the embodiment, the lower electrode 14 and the upper electrode 18 are configure to form a main electrode of the capacitor element according to the modified example of the embodiment. More specifically, as shown in Fig. 2, a positive electrode terminal P is connected to the upper electrode 18, and a negative electrode terminal N is connected to the lower electrode 14.

In this case, a silicon substrate can be applied to the semiconductor substrate 3, for example, and a silicon oxide layer can be applied to the insulating layer 5.

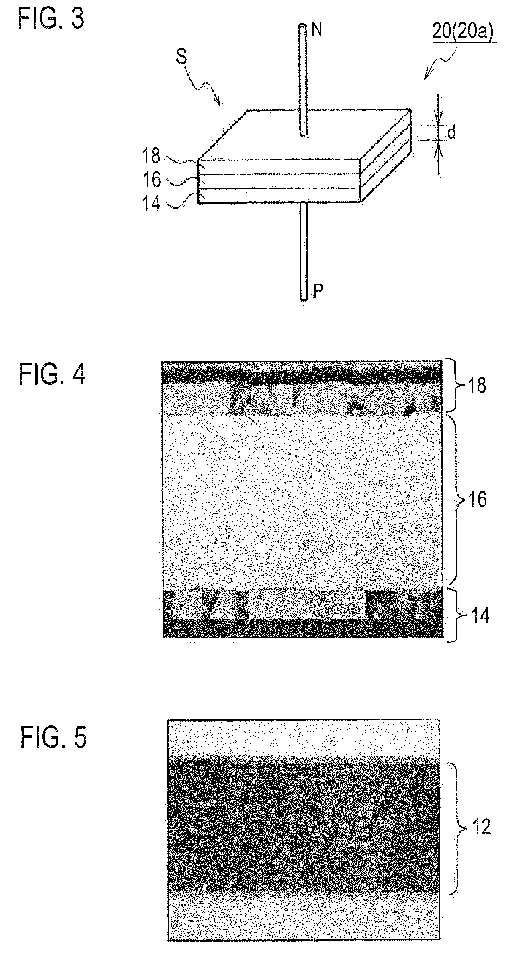

As shown in Fig. 3, the schematic bird's-eye view structure of the capacitor elements 20 (20a) according to the embodiment and the modified example thereof can be considered as the upper electrode 18 connected to the positive electrode terminal P and the lower electrode 14 connected to the negative electrode terminal N being disposed in parallel plate structure via the dielectric layer 16 of which the thickness is d. In the embodiment, an area at the opposing sides of the upper electrode 18 and the lower electrode 14 is S.

In the multilayered structure and the capacitor element according to the modified example of the embodiment, an example of a TEM photograph of the dielectric layer 16 is represented as shown in Fig. 4, and an example of a TEM photograph of the buffer layer 12 is represented, as shown in Fig. 5.

In the embodiment, the buffer layer 12 has the function of improving a property of the surface of the substrate 10, and has a favorable effect on subsequent film growth, in the multilayered structure and the capacitor element according to the embodiment. In the MIM structure of the upper electrode 18/the dielectric layer 16/the lower electrode 14, a quality of the film of the dielectric layer 16 can be improved, and thereby improving adhesibility of the MIM.

Similarly, the buffer layer 12 has the function of improving a property of the insulating layer 5 on the surface of the semiconductor substrate 3, and has a favorable effect on subsequent film growth, in the multilayered structure and the capacitor element according to the modified example of the embodiment. More specifically, in the MIM structure of the upper electrode 18/the dielectric layer 16/the lower electrode 14, a quality of the film of the dielectric layer 16 can be improved, and thereby improving adhesibility of the MIM.

The buffer layer 12 can be formed of TiAlN, IrTa, or CuTa. Moreover, it is preferable that the thickness of the buffer layer 12 is approximately 500 angstroms, and the buffer layer 12 is an amorphous layer and has a low resistivity.

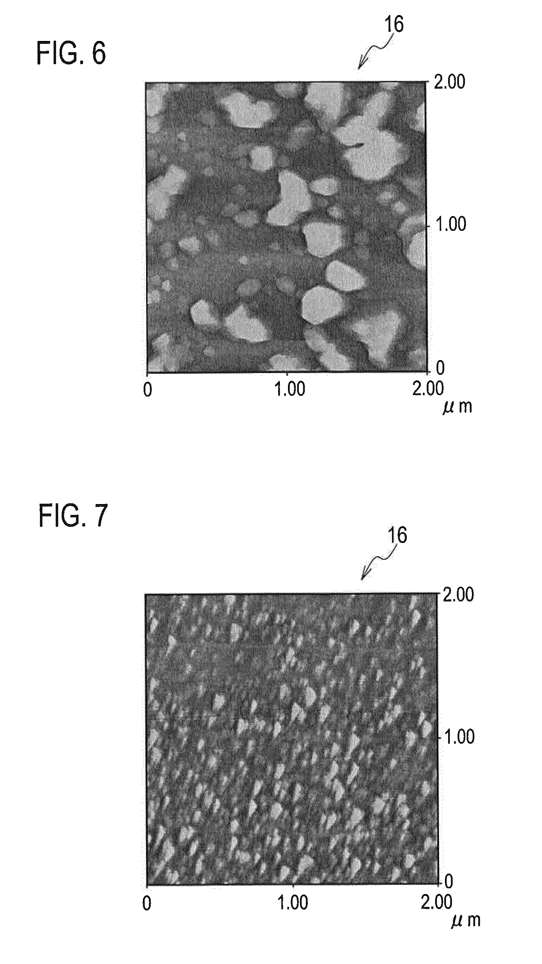

Fig. 6 shows an example of an Atomic Force Microscope (AFM) photograph on a surface of the dielectric layer 16 in a sample formed without forming a buffer layer 12, and Fig. 7 shows an example of an AFM photograph on the surface of the dielectric layer 16 in a sample formed with forming the buffer layer 12, in the structure of the multilayered structure and the capacitor element according to the modified example of the embodiment. In the example shown in Fig. 6, aggregation and sparse portions in a BN film composing the dielectric layer 16 are observed, and therefore the film quality of the dielectric layer 16 is reduced. On the other hand, in the example shown in Fig. 7, no aggregation is observed in the BN film composing the dielectric layer 16, and therefore an evenness of the BN film is improved as compared with that shown in Fig. 6.

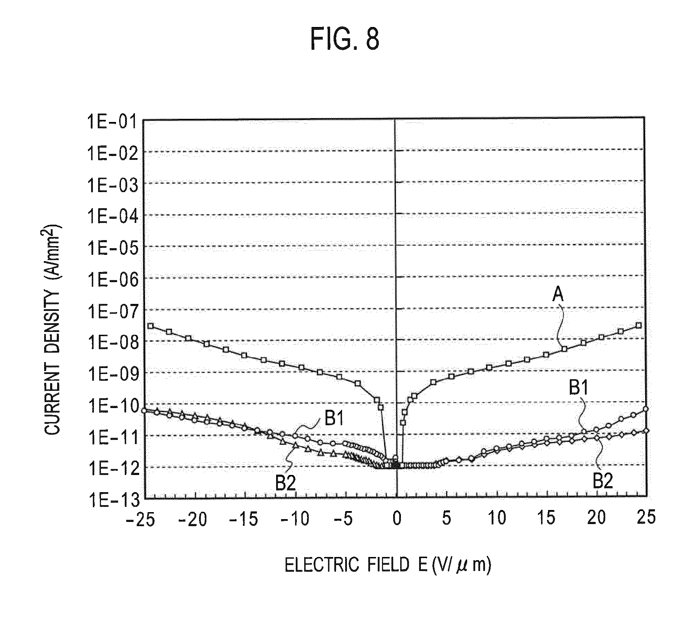

Fig. 8 shows a relationship between current density (A/mm$^2$) and an electric field (v/$\mu$m) in which the upper electrode is a positive electrode (plus) and the lower electrode is a negative electrode (minus), in the structure of the multilayered structure and the capacitor element according to the modified example of the embodiment. In this case, the curved line A indicates an example of characteristics in the case of without buffer layer, the curved line B1 indicates an example of characteristics in the case of using IrTa as the buffer layer 12, and the curved line B2 indicates an example of characteristics in the case of using TiAlN as the buffer layer 12.

No remarkable difference in leakage characteristics between the forward direction and the reverse direction of the MIM structure is perceived, and leakage current density is also reduced to equal to or less than $1 \times 10^{-10}$ (A/mm$^2$). On the other hand, it is understood that leakage characteristics in the case of using no buffer layer is increased approximately equal to or greater than two digits, and therefore the film quality of the dielectric layer 16 is reduced, as compared with the leakage characteristics in both of forward direction and reverse direction of the MIM structure in the case of using IrTa as the buffer layer 12 or the case of using TiAlN as the buffer layer 12.

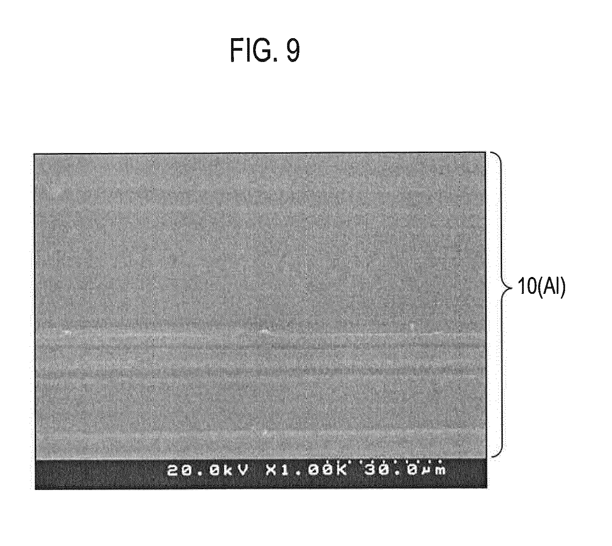

Fig. 9 shows an example of an SEM photograph of a surface of Al foil in the case of applying the Al foil as the substrate 10, in the structure of the multilayered structure and the capacitor element according to the embodiment.

In the multilayered structure and the capacitor element according to the embodiment, it is confirmed that the characteristics of the MIM structure composed of the upper electrode 18/the dielectric layer 16/the lower electrode 14 are excellent by disposing the buffer layer 12 on the substrate 10 composed of the metallic foil even if using a metallic foil having roughness or cavities etc., as the substrate.

A roll method, a multi-layering technique, etc. can be applied to the multilayered structure and the capacitor element according to the embodiment by using the metallic foil as a substrate 10 at the time of fabricating the capacitor. Moreover, the effective area can be extended so as to realize series/parallel connections. As a result, the capacitance value can be increased by the parallel connection and a breakdown voltage is improved by the series connection.

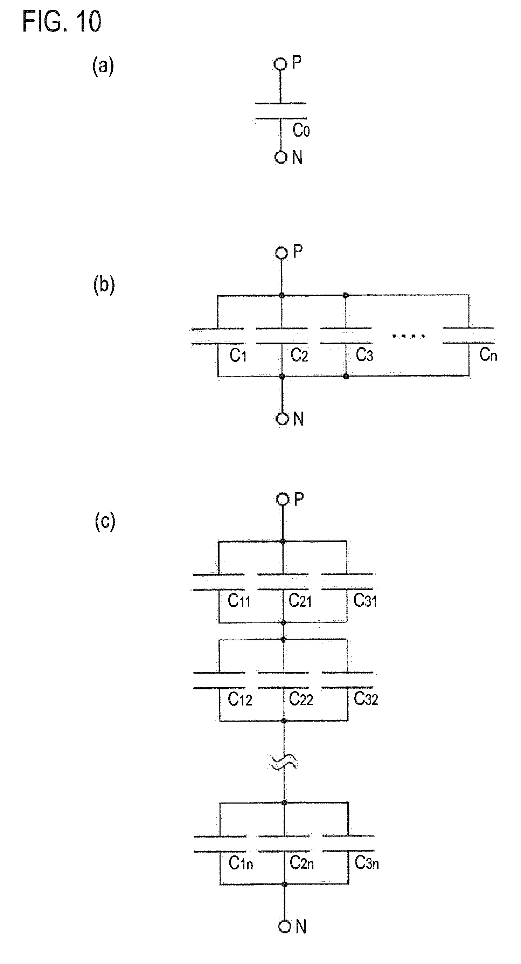

Fig. 10(a) shows an example of a circuit configuration of the capacitor element according to the embodiment, including a capacitor $C_0$, which is an example of a single element, Fig. 10(b) shows a configuration example of connecting capacitors $C_1$, $C_2$, ..., $C_n$ in parallel, and Fig. 10 (c) shows a configuration example of connecting capacitors: $C_{11}$, $C_{12}$, ..., $C_{1n}$; $C_{21}$, $C_{22}$, ..., $C_{2n}$; ...; $C_{31}$, $C_{32}$, ..., $C_{3n}$ in series parallel.

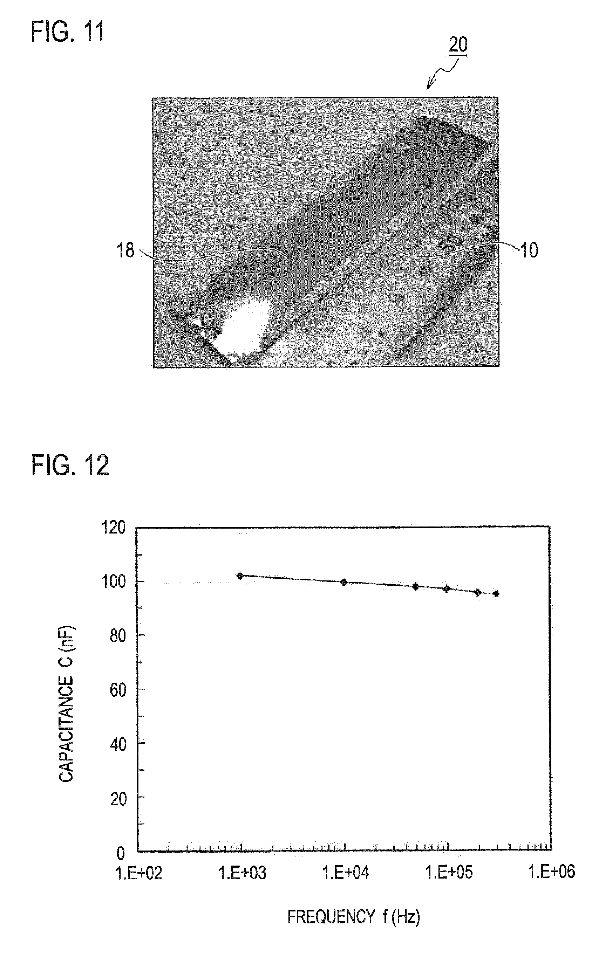

Fig. 11 shows an example photograph of a prototype formed on the substrate 10 composed of the metallic foil, in the capacitor element 20 according to the embodiment. In the embodiment, an electrode sizes of the upper electrode 18 are approximately 65 mm $\times$ approximately 20 mm.

Moreover, Fig. 12 shows an example of frequency characteristics of capacitance C of the capacitor element according to the embodiment formed on the metallic foil. In the embodiment, the capacitor element of which the capacitance value is greater than 0.1 $\mu$F on a large area can be realized by forming the buffer layer 12. In the example of characteristics shown in Fig. 12, the capacitance value C (nF) is approximately constant which is 0.1 $\mu$F up to the frequency of approximately f= 300 kHz.

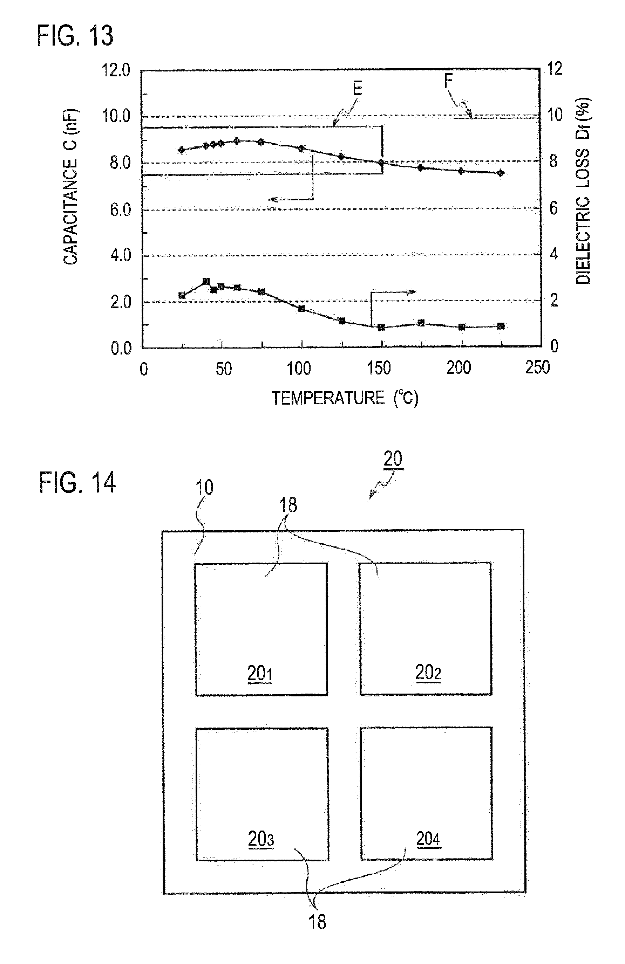

Fig. 13 shows an example of temperature characteristics of capacitance C and dielectric loss $D_f$ in the capacitor element according to the embodiment formed on the metallic foil. Moreover, Fig. 14 shows a schematic front surface pattern configuration of the capacitor element 20 used for measurement. A size of each upper electrode 18 of a plurality of the element capacitors $20_1$, $20_2$, $20_3$, $20_4$ fabricated on the metallic substrate 10 is approximately 10 mm squares.

In the capacitor element according to the embodiment shown in Fig. 13, an amount of variation of the capacitance value C is small and the dielectric loss $D_f$ is also stable, from room temperature to approximately 225 degrees C.

The region E shown in Fig. 13 indicates capacity deviation within a range of plus/minus 10% up to 150 degrees C. As shown in Fig. 13, the capacitor element according to the embodiment falls capacity deviation within a range of plus/minus 10% up to approximately 225 degrees C.

The dashed line F shown in Fig. 13 indicates 10% of level as a specification of the dielectric loss $D_f$. As shown in Fig. 13, in the capacitor element according to the embodiment, a value of the dielectric loss $D_f$ is equal to or less than approximately 3% within a range from room temperature to the 225 degrees C.


**(Example of device made by laminating method)**

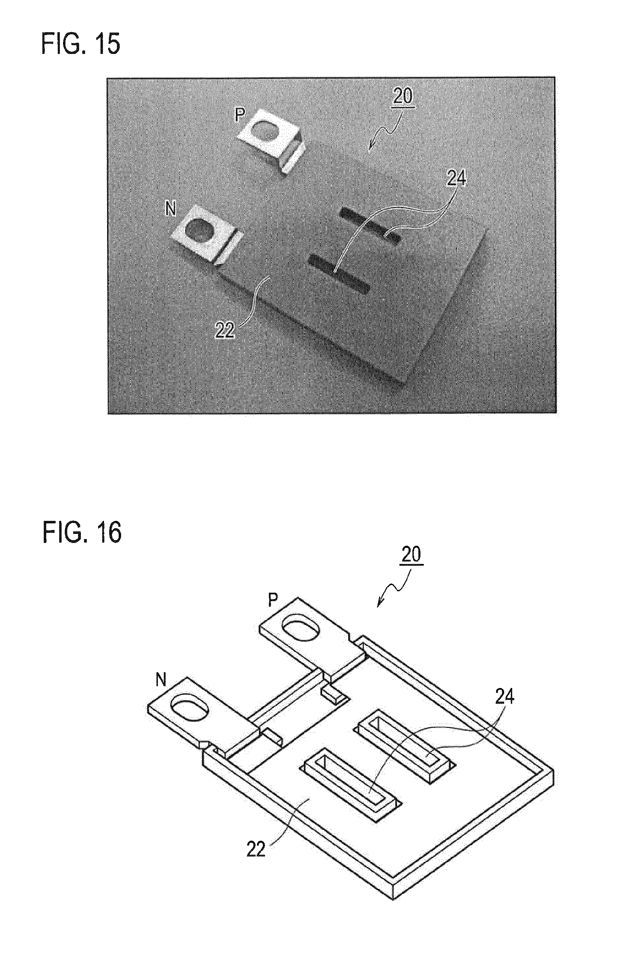

Fig. 15 shows an example of an external photograph of a device formed of the capacitor element 20 with a laminating method, according to the embodiment. Fig. 16 shows a schematic bird's-eye view structure in an inside of a package of the capacitor element 20 shown in Fig. 15. For example, as for the package size except an electrode terminal portion, the length is approximately 39 mm, the width is approximately 33 mm, and the thickness is approximately 3 mm.

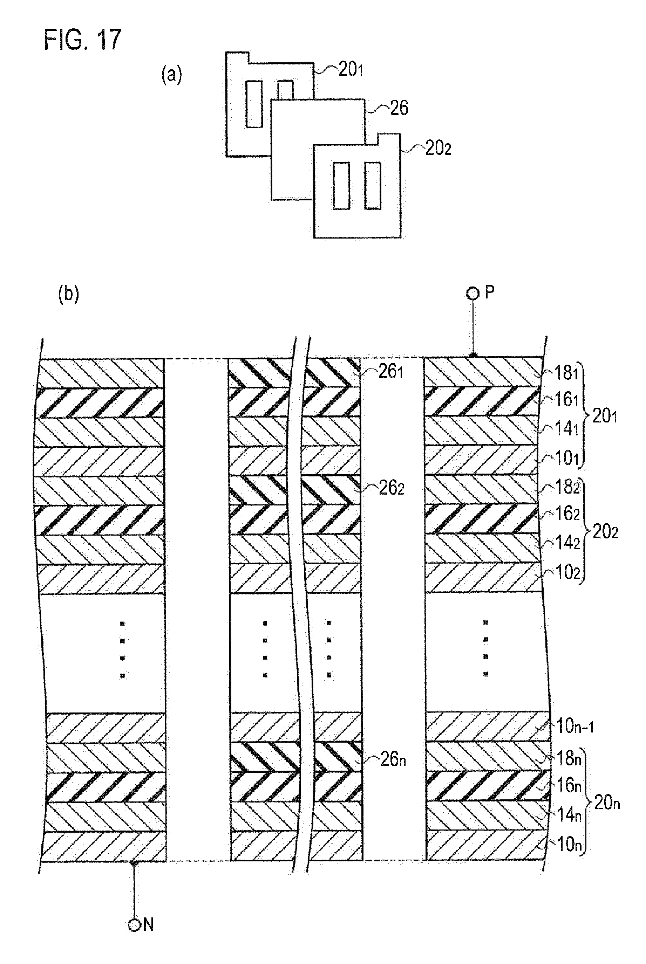

Fig. 17 (a) shows an aspect that two sheets of the element capacitors $20_1$, $20_2$ are layered via a separator 26, in the capacitor element according to the embodiment.

Moreover, Fig. 17(b) shows a schematic cross-sectional structure in which n layers of the element capacitors $20_1$, $20_2$, ..., $20_n$ respectively are laminated via the separators $26_1$, $26_2$, ..., $26_n$, in the capacitor element according to the embodiment. Although buffer layers $12_1$, $12_2$, ..., $12_n$ are actually disposed between the metallic substrates 101, 102, ..., 10n and the lower electrodes $14_1$, $14_2$, ..., $14_n$, illustration thereof is omitted in Fig. 17(b).

In Fig. 16, the capacitor bodies respectively are laminated to be formed via the separators, as shown in Figs. 17 (a) and 17 (b). A resin layer 22 is formed of a heat-resistant resin. Both casing structure and molding structure can be adopted for a mounting structure of the capacitor element 20 according to the embodiment.

As shown in Figs. 17(a) and 17(b), the capacitor element 20 according to the embodiment may include a plurality of the element capacitors $20_1$, $20_2$, ..., $20_n$, and the plurality of the element capacitors $20_1$, $20_2$, ..., $20_n$ may be laminated to be mutually connected in series so that the separators $26_1$, $26_2$, ..., $26_n$ are respectively inserted therebetween.

Moreover, the capacitor element 20 according to the embodiment may have a plurality of the element capacitors, and the element capacitors may be mutually connect in parallel.

Moreover, in the capacitor element 20 according to the embodiment, the element capacitors mutually connected in series may further be mutually connected in parallel.

**(Fabrication method)**

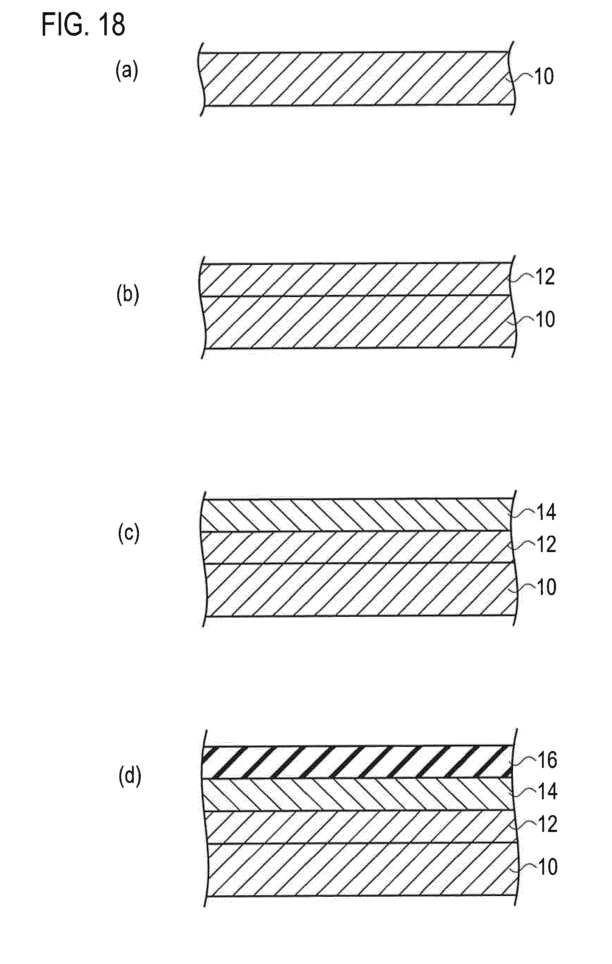

In a fabrication method of the capacitor element according to the embodiment, pre-processing of the substrate 10 is illustrated as shown in Fig. 18 (a), a process of forming the buffer layer 12 on the substrate 10 is illustrated as shown in Fig. 18(b), a process of forming the lower electrode 14 on the buffer layer 12 is illustrated as shown in Fig. 18(c), and a process of forming the dielectric layer 16 on the lower electrode 14 is illustrated as shown in Fig. 18(d).

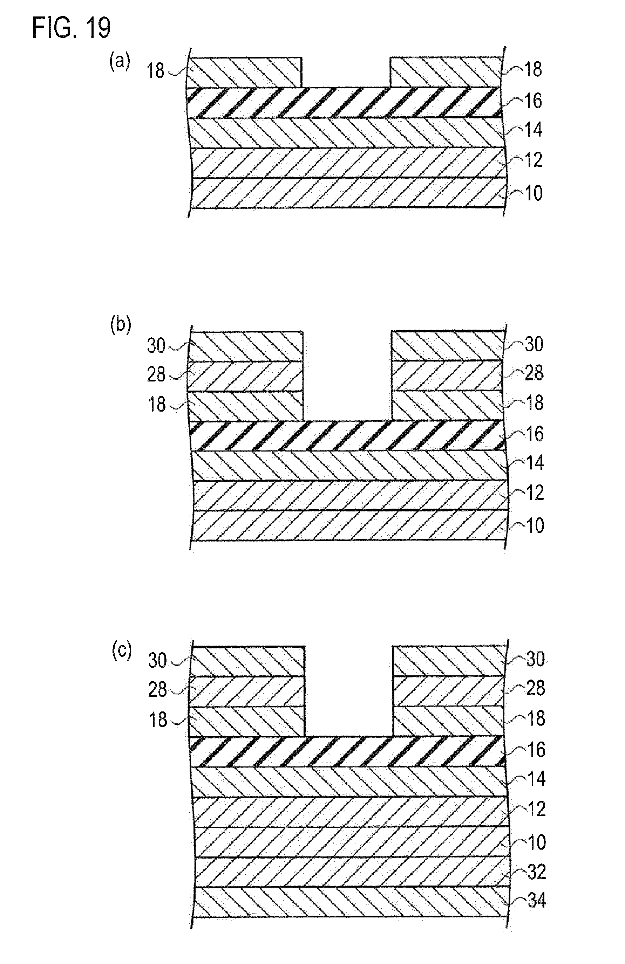

Furthermore, in the fabrication method of the capacitor element according to the embodiment, a process of pattern-forming the upper electrode 18 on the dielectric layer 16 is illustrated as shown in Fig. 19(a), a process of forming the Ni layer 28 on the upper electrode 18 and forming the Ag layer 30 on the Ni layer 28 one by one is illustrated as shown in Fig. 19(b), and a process of forming the Ni layer 32 on a back side surface of the substrate 10 and forming the Ag layer 34 on the Ni layer 32 one by one is illustrated as shown in Fig. 19(c).

The fabrication method of the capacitor element according to the embodiment includes: pre-processing the substrate 10; forming the buffer layer 12 on the substrate 10; forming the lower electrode 14 on the buffer layer 12; forming the dielectric layer 16 on the lower electrode 14, the dielectric layer 16 composed nitride; and forming the upper electrode 18 on the dielectric layer 16.

The substrate 10 may be formed of a metallic foil.

Moreover, a substrate may be formed of a semiconductor substrate 3 (refer to Fig. 2).

Moreover, the fabrication method further includes forming the insulating layer 5 on the semiconductor substrate 3, wherein the buffer layer 12 may be formed on the insulating layer 5.

Each step of forming the buffer layer 12, the forming the lower electrode 14, forming the dielectric layer 16, and forming the upper electrode 18 may be implemented by a sputtering process.

Each sputtering process may be implemented in the same chamber.

Moreover, the sputtering process may be implemented with a roll-to-roll process.

The fabrication method may further include an assembly process of laminating a plurality of the capacitor elements formed by the above-mentioned fabrication method of the capacitor element so that the separators are respectively inserted therebetween.

Hereinafter, the fabrication method of the capacitor element according to the embodiment will now be explained in process order.

(a) Firstly, as shown in Fig. 18 (a), the substrate 10 composed of the metallic foil is washed as pre-processing. Organic washing and acid washing are implemented in the aforementioned washing process. The metallic foil can be formed from any one of or any laminated structure of Ti, Ni, Cu, Mo, Al, Nb, Ta, Ag, Zr, Au, Pt, W, Ir, V, stainless-steel (SUS), 42Alloy, nickel silver, and brass.

(b) Next, as shown in Fig. 18 (b), the buffer layer 12 is formed on the substrate 10 by the sputtering process. TiAlN, IrTa, or CuTa is applicable to the buffer layer 12, for example. Moreover, the buffer layer 12 may have an amorphous conductor.

(c) Next, as shown in Fig. 18(c), the lower electrode 14 is formed on the buffer layer 12 by the sputtering process. In the embodiment, vacuum evaporation technology may be applied thereto instead of the sputtering process. In the embodiment, Cr, Mo, Al, Ta, Cu, Ti, Ni, W, or Ag is applicable to materials of the lower electrode 14, as long as it is a single metal. CuTa or TiW is applicable thereto as long as it is an alloy. $Ta_2N$ or TiN is applicable thereto as long as it is nitride. $WSi_2$ or TiSi is applicable thereto as long as it is a silicide. TaB is applicable thereto as long as it is a boride.

(d) Next, as shown in Fig. 18(d), the dielectric layer 16 is formed on the lower electrode 14 by the sputtering process. The dielectric layer 16 may include any one of BN, BCN, CN, BAlN, BSiN, AlN or SiN. Moreover, the dielectric layer 16 include an amorphous layer.

(e) Next, as shown in Fig. 19(a), the upper electrode 18 is formed on the dielectric layer 16 by the sputtering process. In the embodiment, a shadow mask is used for the sputtering process. Moreover, vacuum evaporation technology may be applied thereto instead of the sputtering process. The upper electrode 18 can be formed using the similar material to the lower electrode 14.

(f) Next, as shown in Fig. 19(b), the Ni layer 28/Ag layer 30 used as a contact metal is formed on the upper electrode 18 one by one by using plating technology. In addition, sputtering technology, vacuum evaporation technology, etc. may be applied thereto instead of the plating technology.

(g) Next, an intermediate inspection is implemented by using a probe test etc.

(h) Next, as shown in Fig. 19(c), the Ni layer 32/Ag layer 34 is formed on the back side surface of the substrate 10 one by one by using the plating technology. In addition, sputtering technology, vacuum evaporation technology, etc. may be applied thereto instead of the plating technology. The element capacitor is completed through the above-mentioned processes.

(i) Next, a plurality of the element capacitors are connected one by one so as to be multilayered. More specifically, the fabrication method of the capacitor element according to the embodiment may further include an assembly process of laminating a plurality of the capacitor elements formed through the above-mentioned processes so that the separators 26 are respectively inserted therebetween.

(j) Next, external electrode terminals P, N are connected to the plurality of the element capacitors connected so as to be multilayered.

(k) Next, the capacitor element is housed in a case and then sealed with a resin.

The capacitor element according to the embodiment is completed through the above-mentioned processes.

Although a fabricating process in the case of using the semiconductor substrate 3 is also similar thereto, the substrate 10a in which the insulating layer 5 is formed on the semiconductor substrate 3 is used at a start, and then the substrate 10a is washed in the pre-processing in the same manner as that show in Fig. 18(a). Organic washing and acid washing are implemented in the aforementioned washing process. The subsequent process is the same as that of above-mentioned process.

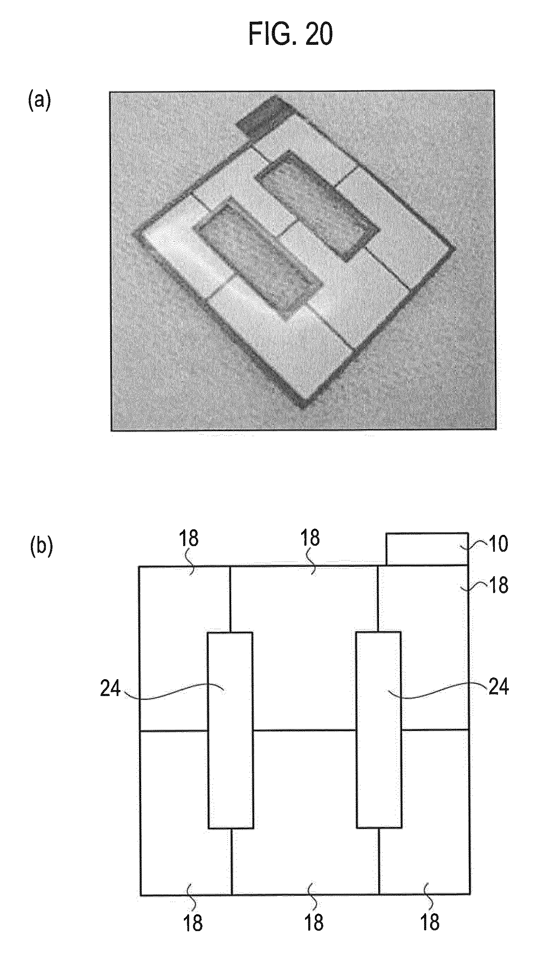

Fig. 20(a) shows an example of an outside surface photograph of the capacitor element according to the embodiment. Fig. 20(b) is a schematic front surface pattern configuration corresponding to that in Fig. 20(a).

In the capacitor element according to the embodiment, the element capacitor includes two apertures 24, for example. Moreover, as shown in Fig. 20(b), the upper electrode 18 may be divided into a plurality of portions.

As an example of characteristics of the prototype, an approximately 1-$\mu$F capacitor element is obtained by connecting three pieces of approximately 0.3-$\mu$F element capacitors $20_1$ in series, and then connecting ten pieces thereof in parallel. For example, an approximately 600V-breakdown voltage can be designed.

Moreover, in the fabrication method of the capacitor element according to the embodiment, each step of forming the buffer layer 12, the forming the lower electrode 14, forming the dielectric layer 16, and forming the upper electrode 18 can be implemented by a sputtering process, and each sputtering process may be implemented in the same chamber. In this case, multiple times of the sputtering processes may be implemented by roll-to-roll process.

In the capacitor element according to the embodiment, it can be assembled to be completed as a device, after a depositing process for each layer by using the minimum number of times of the sputtering processes.

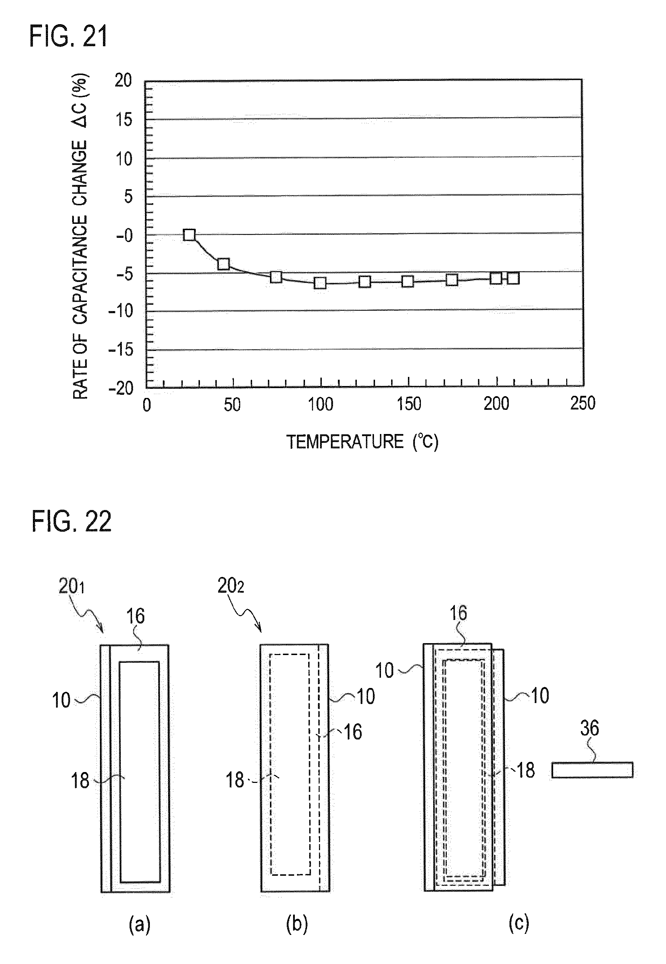

Fig. 21 shows an example of temperature characteristics of the rate of capacitance change $\Delta$C (%), in the capacitor element according to the embodiment fabricated through the above-mentioned fabricating processes. In the embodiment, the rate of capacitance change $\Delta$C (%) is expressed by the following equation:

$$\Delta C\ (\%)\ =\ (C(T)-C(RT))/C(RT) \qquad\qquad (1)$$

where C(T) is capacitance at temperature T, and C(RT) is capacitance at room temperature.

In the capacitor element according to the embodiment, the rate of capacitance change $\Delta$C (%) with respect to room temperature is within a range of less than plus/minus 10%, over a wide range from room temperature to equal to or greater than 200 degrees C. As a comparative example, the rate of capacitance change $\Delta$C (%) with respect to room temperature in an example of a ceramic capacitor is approximately minus 50% at 200 degrees C.

**(Example of device made by a roll method)**

Fig. 22(a) shows a front surface pattern configuration of a first element capacitor $20_1$ applied to an example of a device made by a roll method of the capacitor element according to the embodiment, Fig. 22(b) shows a back surface pattern configuration of a second element capacitor $20_2$ applied thereto, and Fig. 22 (c) is a front surface pattern configuration diagram before winding up the laminated first element capacitor $20_1$ and second element capacitor $20_2$ onto a core rod 36 applied thereto.

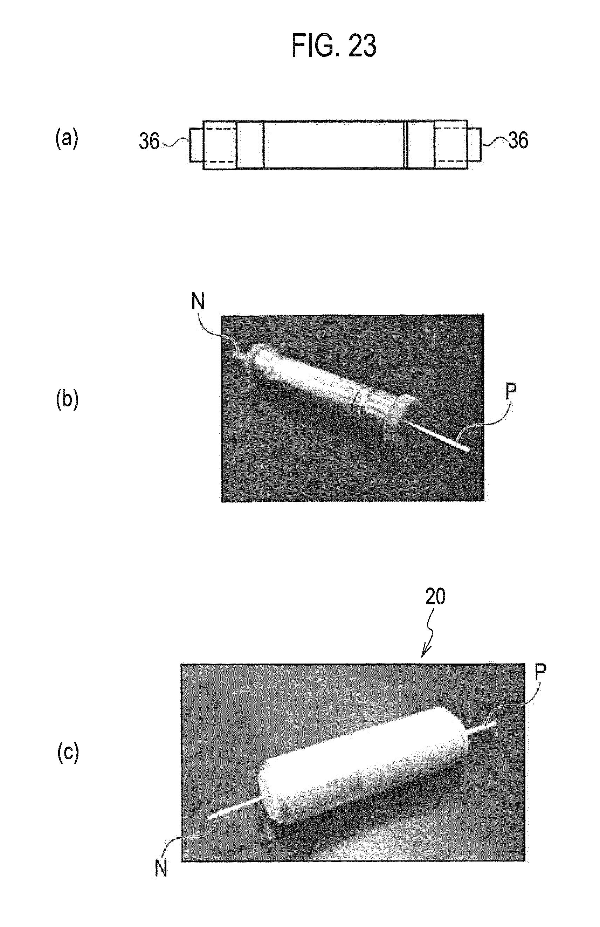

Fig. 23(a) shows a front surface pattern configuration after winding up the laminated first element capacitor $20_1$ and second element capacitor $20_2$ onto a core rod 36, Fig. 23 (b) shows an example of an external photograph of a wound state, and Fig. 23 (c) shows an example of an external photograph in a state where the capacitor element according to the embodiment is connected to external electrode terminals P, N, and is housed in a case.

More specifically, the capacitor element according to the embodiment includes: the first element capacitor $20_1$ and the second element capacitor $20_2$; and a core rod 36 for the purpose of winding up the first element capacitor $20_1$ and the second element capacitor $20_2$, wherein the upper electrode 18 of the first element capacitor $20_1$ and the upper electrode 18 of the second element capacitor $20_2$ are bonded to each other, and then the bonded first and second element capacitor $20_1$, $20_1$ are wound up on the core rod 36, and thereby a device can be made by a roll method.

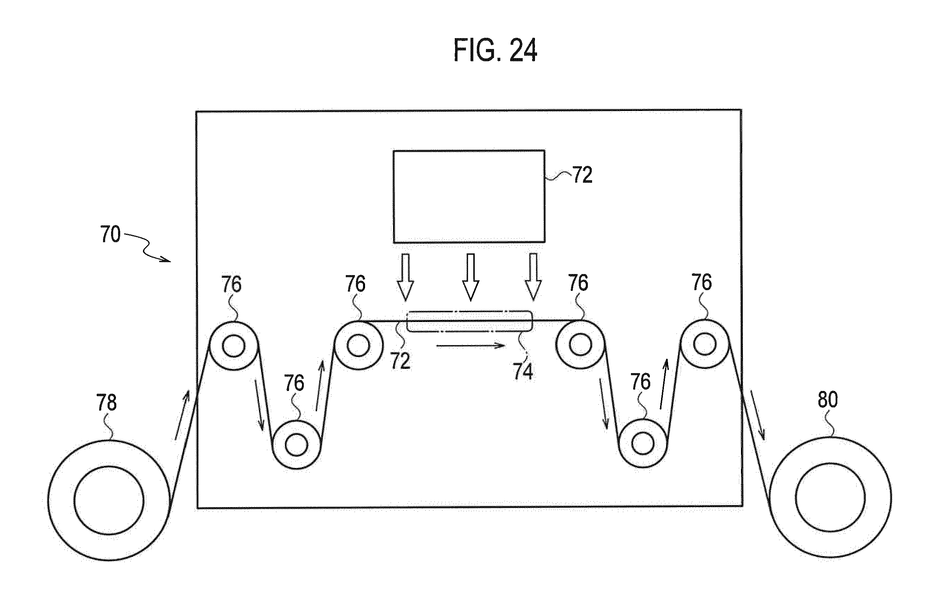

In a fabricating apparatus applicable to the fabrication method of the capacitor element according to the embodiment, Fig. 24 shows a configuration of the capacitor fabricating apparatus which can mass-produce the capacitor with a roll-to-roll method by applying the same chamber to the sputtering process.

As shown in Fig. 24, the capacitor fabricating apparatus using the roll-to-roll method applicable to the fabrication of the capacitor according to the embodiment includes: a material supply roller 78; a material winding roller 80; a plurality of tension rollers 76; a material 72 transferred via the tension rollers 76 between the material supply roller 78 and the material winding roller 80; and a vacuum chamber 70 configured to supply a target material by sputtering from the film-forming material supplying target 72, in a film formation area 74 on the material 72. In the embodiment, the sputtering process of film formation for a plurality of layers in the film formation area 74 can be implemented with the roll-to-roll process in the vacuum chamber 70.

According to the capacitor fabricating apparatus using the roll-to-roll method shown in Fig. 24, the capacitors according to the embodiment can be mass-produced since the buffer layer 12, the lower electrode 14, the dielectric layer 16, and the upper electrode 18, etc. can efficiently be formed with the roll-to-roll method.

**(Application example)**

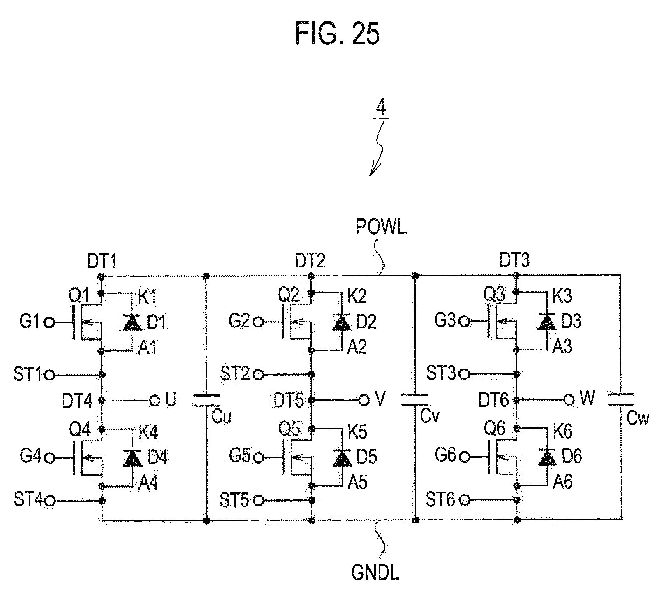

Fig. 25 shows a schematic circuit configuration of a three-phase AC inverter equipment 4 composed by arranging six pieces of the power module semiconductor devices 2. As shown in Fig. 25, the capacitor element according to the embodiments Cu, Cv, Cw are respectively connected to between power line POWL and grounding line (earthing terminal) GNDL of each of U-phase, V-phase, and W-phase half bridge inverters.

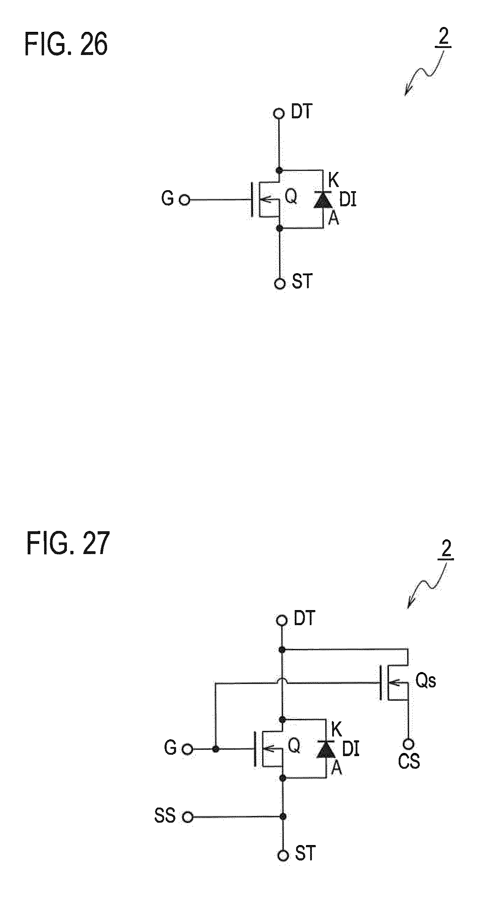

Fig. 26 is a schematic circuit representative of a 1-in-1 module, which is a power module semiconductor device 2 applicable to the three-phase AC inverter equipment 4 shown in Fig. 25. Moreover, a details circuit representation of the 1-in-1 module is represented as shown in Fig. 27.

In the configuration of the 1-in-1 module, as shown in Fig. 26, one MOSFET Q is included in one module.

The diode DI connected to the MOSFETQ inversely in parallel is shown in Fig. 27. A main electrode of the MOSFETQ is expressed with a drain terminal DT and a source terminal ST. Moreover, as shown in Fig. 27, a sense MOSFET Qs is connected to the MOSFETQ in parallel. The sense MOSFET Qs is formed as a minuteness transistor in the same chip as the MOSFET Q. In Fig. 27, reference numeral SS denotes a source sense terminal, reference numeral CS denotes a current sense terminal, and reference numeral G denotes a gate signal terminal.

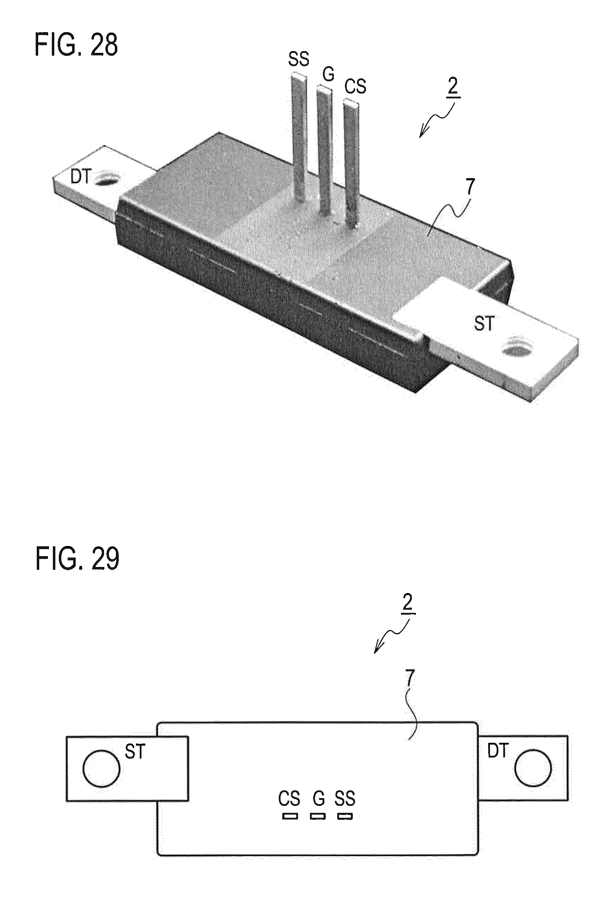

A schematic bird's-eye view configuration of the 1-in-1 module is illustrated as shown in Fig. 28. In the power module semiconductor device 2 having the straight wiring structure, the signal terminals SS, G, CS are arranged so as to be projected in a vertical direction from a resin layer 7, as shown in Fig. 28.

Moreover, Fig. 29 shows a schematic plane configuration of the power module semiconductor device 2 having the straight wiring structure.

**(Vertically stacked structure)**

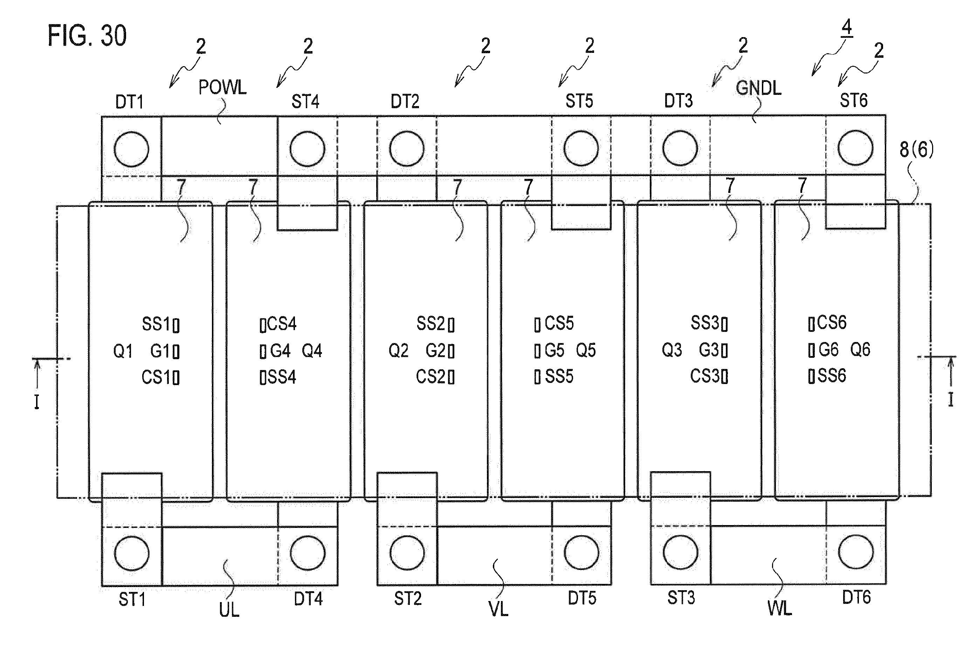

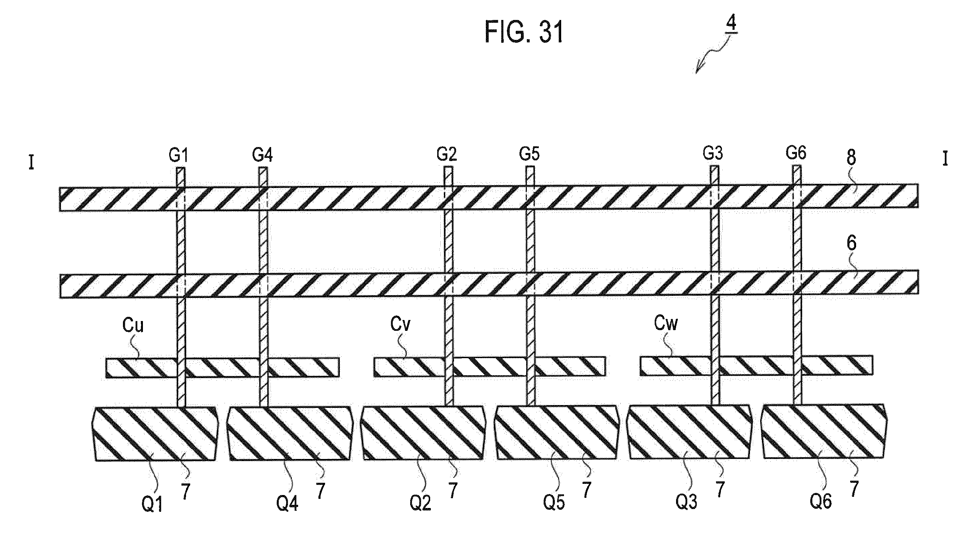

In a schematic plane configuration also including connection wiring (bus bar) electrodes (GNDL, POWL) connected between each power terminal in the three-phase AC inverter equipment 4 composed by arranging the six pieces of the power module semiconductor devices 2 having the straight wiring structure, Fig. 30 shows an example of disposing a control substrate 6 and a power source substrate 8 at an upper portion of the three-phase AC inverter equipment 4, and Fig. 31 shows a schematic cross-sectional structure taken in the line I-I of Fig. 30. Although the capacitor element Cu, Cv, Cw are omitted from Fig. 30 in order to avoid complicatedness, the capacitor element Cu, Cv, Cw are actually disposed on the power module semiconductor device 2, as shown in Fig. 31.

As shown in Figs. 30 and 31, the three-phase AC inverter equipment 4 composed by arranging six pieces of the power module semiconductor devices 2 having the straight wiring structure includes: a control substrate 6 disposed on a plurality of the power module semiconductor devices 2 disposed in parallel, the control substrate 6 configured to control the power module semiconductor devices 2; a power source substrate 8 disposed on the plurality of the power module semiconductor devices 2 disposed in parallel, and configured to supply a power source to the power module semiconductor devices 2 and the control substrate 6; and capacitor elements Cu, Cv, Cw disposed on half bridge inverters (Q1, Q4), (Q2, Q5), (Q3, Q6) composed of every two pieces of the power module semiconductor devices 2 among the plurality of the power module semiconductor devices 2 disposed in parallel which with each other by a power module semiconductor device 2. In this case, the capacitor element according to the embodiment is applied to the capacitor elements Cu, Cv, Cw. The length of the vertical direction in which the signal terminals CS, G, SS are extended is an enough length to connect the signal terminals CS, G, SS to the control substrate 6 and the power source substrate 8. In the example shown in Fig. 31, the capacitor element Cu, Cv, Cw are disposed between the power module semiconductor device 2 and the control substrate 6, and the signal terminals CS, G, SS pass through each aperture 24 of the capacitor elements Cu, Cv, Cw.

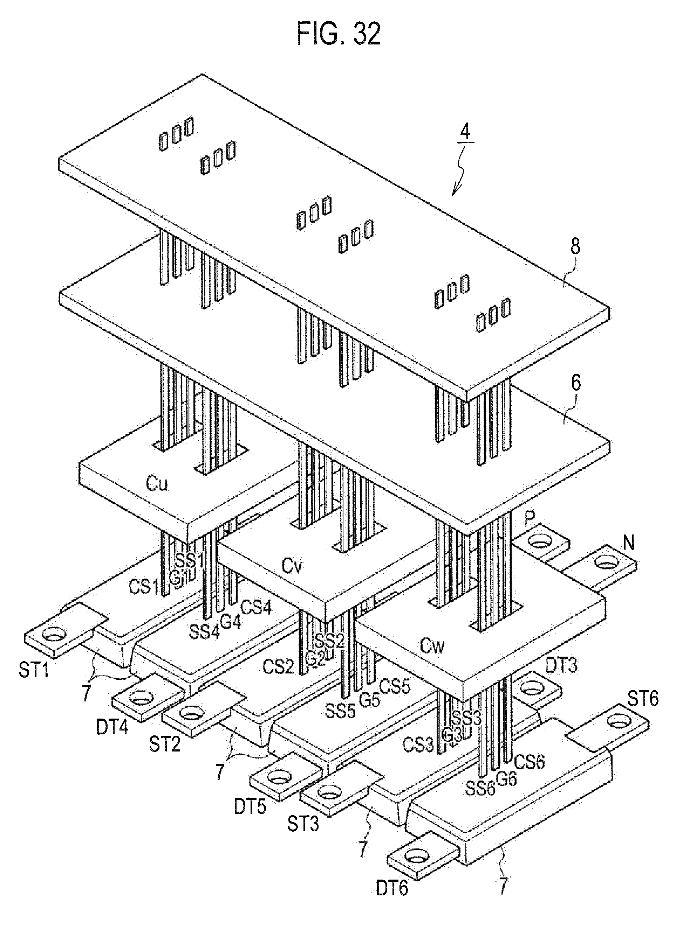

Furthermore, Fig. 32 is a schematic bird's-eye view configuration of the three-phase AC inverter 4 configured to arrange six power module semiconductor devices 2, in which the capacitor elements Cu, Cv, Cw according to the embodiment are mounted thereon, and the control substrate 6 and the power source substrate 8 are arranged thereon. As shown in Fig. 32, the signal terminals (CS1, G1, SS1), (CS2, G2, SS2), (CS3, G3, SS3), (CS4, G4, SS4), (CS5, G5, SS5), (CS6, G6, SS6) of the six pieces of the power module semiconductor devices 2 are respectively connected to the capacitor elements Cu, Cv, Cw, the control substrate 6, and the power source substrate 8 in vertical direction, thereby composing the three-phase AC inverter equipment 4. Note that detailed patterns of the control substrate 6 and the power source substrate 8 are omitted from Fig. 32 for the purpose of simplification. Moreover, although distances in a vertical direction between the power module semiconductor device 2, and the capacitor element Cu, Cv, Cw which function as a snubber capacitor, the control substrate 6, and the power source substrate 8 are respectively illustrated so as to be relatively long distances in Fig. 32 in order to clarify the details of the structure, each distance therebetween is actually shortened.

In the three-phase AC inverter equipment composed by arranging six pieces of the power module semiconductor devices 2 having the straight wiring structure, the capacitor element Cu, Cv, Cw, the control substrate, the power source substrate, the snubber capacitor C, etc. can be easily arranged in the vertically stacked structure, thereby slimming down the system.

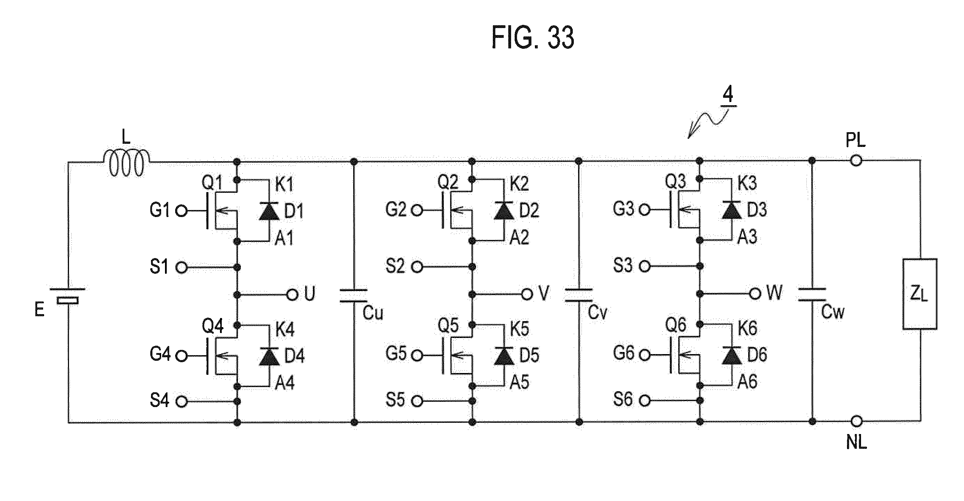

In the three-phase AC inverter equipment composed by arranging six pieces of the power module semiconductor devices 2, Fig. 33 shows a circuit configuration in which the capacitor elements Cu, Cv, Cw according to the embodiment are connected between the power line and the grounding line (earthing line) of each half bridge inverter, and load $Z_L$ is connected between the power supply terminal PL and the ground terminal (earth terminal) NL. When connecting the three-phase AC inverter equipment to the power source E, large surge voltage Ldi/dt is produced by an inductance L included in a connection line due to a high switching speed of the SiC device. For example, the surge voltage Ldi/dt is expressed as follows: Ldi/dt = $3 \times 10^9$ (A/s), where a current change di=300A, and a time variation accompanying switching dt = 100 ns. Although a value of the surge voltage Ldi/dt changes dependent on a value of the inductance L, the surge voltage Ldi/dt is superimposed on the power source V. This surge voltage Ldi/dt can be absorbed by the capacitor elements Cu, Cv, Cw according to the embodiment.

**(Application examples for applying semiconductor device)**

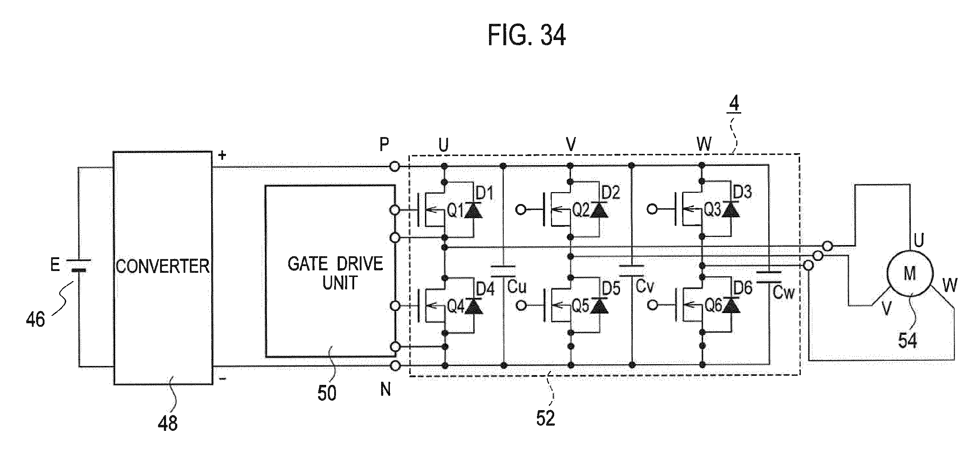

Next, there will now be explained a three-phase AC inverter composed by using the power module semiconductor device 2 with reference to Fig. 34.

As shown in Fig. 34, the three-phase AC inverter includes: a gate drive unit 50; a power module unit 52 connected to the gate drive unit 50 and a three-phase alternating current (AC) motor unit 54. U-phase, V-phase, and W-phase inverters are respectively connected to the three-phase AC motor unit 54 so as to correspond to U phase, V phase, and W phase of the three-phase AC motor unit 54, in the power module unit 52. The capacitor elements Cu, Cv, Cw according to the embodiment are respectively connected to the U-phase inverter, V-phase inverter, and-W phase inverter.

In this case, although the gate drive unit 50 is connected to the SiC MOSFETs Q1, Q4 as shown in Fig. 34, the gate drive unit 50 is similarly connected also to the SiC MOSFETs Q2, Q5 and the SiC MOSFETs Q3, Q6 (not shown in Fig. 34).

In the power module unit 52, the SiC MOSFETs Q1, Q4, and the SiC MOSFETs Q2, Q5, and the SiC MOSFETs Q3, Q6 having inverter configurations are connected between a positive terminal P and a negative terminal N of the converter 48 connected to a storage battery (E) 46. Furthermore, diodes D1-D6 are connected inversely in parallel to one another between the source and the drain of the SiC-MOSFETs Q1 to Q6.

Although the structure of single-phase inverter corresponding to U-phase portion of Fig. 34 has been explained, in the power module semiconductor device 2, the three-phase power module unit 52 can also be formed also by similarly forming V phase and W phase inverters.

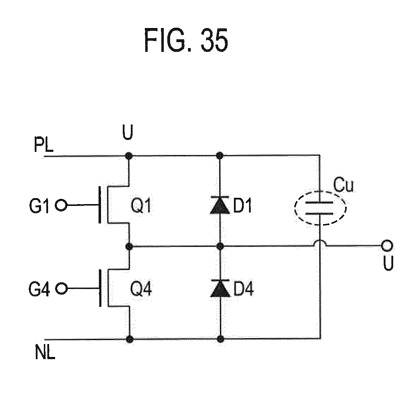

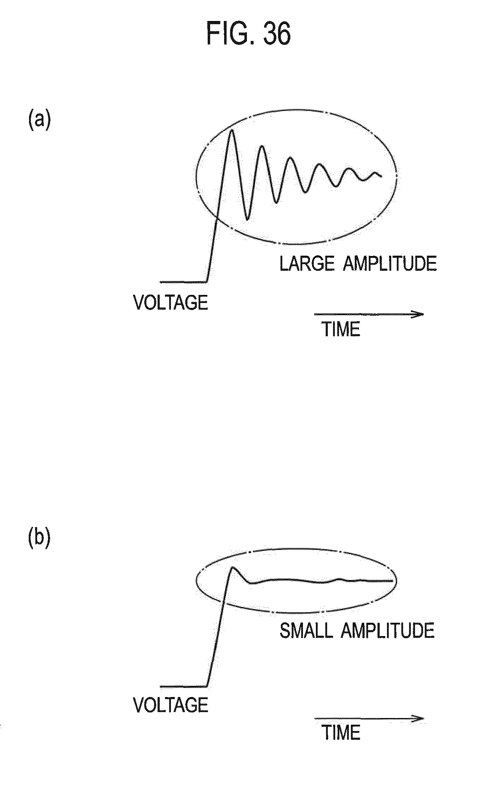

Fig. 35 shows a circuit configuration of the U-phase inverter including the capacitor element according to the embodiment Cu. Moreover, Fig. 36(a) shows an example of a switching voltage waveform in the state where the capacitor element according to the embodiment Cu is removed from the circuit shown in Fig. 35. Fig. 36(b) shows an example of a switching voltage waveform in the state where the capacitor element according to the embodiment Cu is applied thereto.

A shown in Fig. 36(a), in the example of the switching voltage waveform in the state where the capacitor element according to the embodiment Cu is removed therefrom, an amplitude variation of the switching waveform is relatively large.

Meanwhile, in the example of the switching voltage waveform in the state where the capacitor element according to the embodiment Cu is applied thereto, as shown in Fig. 36(b), a amplitude variation of the switching waveform can be reduced.

The capacitor element according to the embodiment is excellent in high-temperature operational stability, and can reduce a switching noise, thereby making easy a high-speed switching operation of inverter circuits. In particular, the capacitor element according to the embodiment can operate also in high-temperature operating environments in SiC inverters.

The capacitor element according to the embodiment can reduce a degradation due to a heat generation by Equivalent Series Resistance (ESR) also in large-current operations.

The capacitor element according to the embodiment is impervious to high-temperature and heat generation environments. Accordingly, if the capacitor element according to the embodiment is applied to operations of high-speed and high-current switching modules as a noise countermeasure capacitor element, the capacitor element can be disposed to nearest devices.

Since the capacitor element according to the embodiment can be disposed to nearest devices, a parasitic inductance can be reduced, and the size and weight of the capacitor element can also be reduced. Moreover, there is no necessity of providing a cooling mechanism. Accordingly, it becomes possible to demonstrate a high speed switching performance of the high-speed and high-current switching module.

**(Cutting tool)**

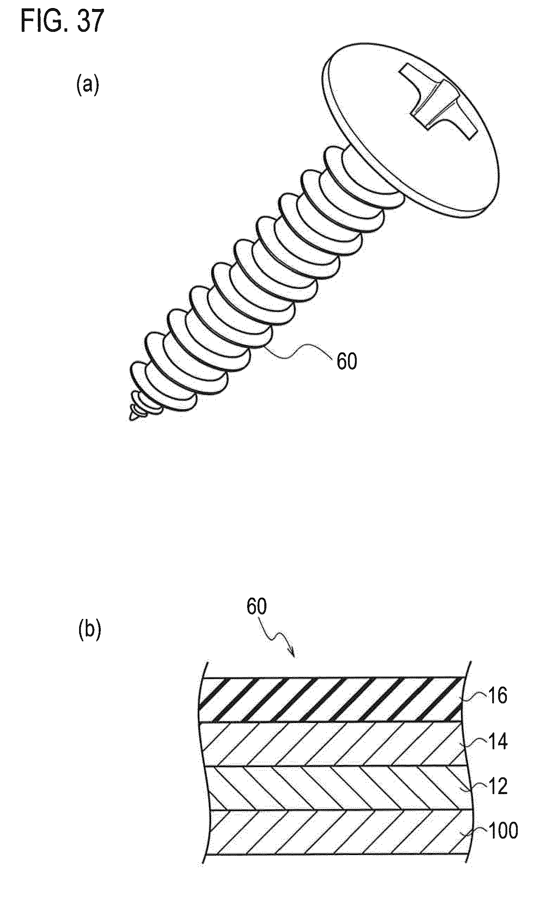

Fig. 37(a) shows a schematic bird's-eye view of a tap screw which is a cutting tool to which the multilayered structure according to the embodiment is applied. Fig. 37 (b) shows a schematic cross-sectional structure of the multilayered structure applicable to the tap screw shown in Fig. 37(a).

More specifically, as shown in Figs. 37 (a) and 37 (b), the cutting tool to which the multilayered structure according to the embodiment is applied, which is a structure of the tap screw, includes: a substrate material 100; a buffer layer 12 disposed on the substrate material 100; a lower electrode 14 disposed on the buffer layer 12; and a dielectric layer 16 disposed on the lower electrode 14, the dielectric layer 16 composed of nitrides.

In the embodiment, the dielectric layer 16 may include an amorphous layer. Moreover, the buffer layer 12 may include an amorphous conductor.

The buffer layer 12 may include TiAlN, IrTa, or CuTa.

Moreover, the dielectric layer 16 may include nitrogen, and may include at least one kind of boron, carbon, aluminum, or silicon.

Moreover, the dielectric layer 16 may include any one of BN, BCN, CN, BAlN, BSiN, AlN or SiN. More specifically, in the multilayered structure according to the embodiment, in the case where there is no upper electrode 18, it is utilized as an ultrahard material if the dielectric layer 16 is formed of BN or AlN, and it can also be used for surface coating of the cutting tools.

In the capacitor element according to the embodiment, serialization and parallelization of the element capacitor becomes easy, and thereby miniaturization and thickness reduction of the device van be realized.

Since nitride has physical properties, such as wide gap characteristics, covalency, oxidation-resistant, etc., the capacitor element according to the embodiment in which the dielectric layer is formed of nitride can be steadily used even at high temperature, equal to or greater than 200 degrees C, for example.

Moreover, the capacitor element according to the embodiment is suitable for a purpose of converting a noise at the time of switching into a heat to be radiated since thermal dispersion characteristics thereof are also relatively high.

As explained above, according to the present invention, there can be provided the multilayered structure, the capacitor element, and the fabrication method of the capacitor element, each excellent in high-temperature stability.

**[OTHER EMBODIMENTS]**

The embodiment has been described herein, as a disclosure including associated description and drawings to be construed as illustrative, not restrictive. This disclosure makes clear a variety of alternative embodiment, working examples, and operational techniques for those skilled in the art.

Such being the case, the embodiment covers a variety of embodiments and the like, whether described or not.

**INDUSTRIAL APPLICABILITY**

The multilayered structure and the capacitor element of the present invention can be operated in particular at high temperatures (equal to or greater than 150 degrees C), and therefore can be applied to electronic equipment, e.g. DC-DC converters containing power capacitors or power capacitors for mobile computing devices, Electric Vehicle (EV) motor driving inverters. The multilayered structure and the capacitor element of the embodiment are further applicable to electronic equipment, e.g. online energy management, load measurement and management, energy storage management, Electric Vehicle (EV) management, solar management, and wind management.

**Reference Signs List**

2: Power module semiconductor device
3: Semiconductor substrate
4: Inverter equipment
5: Insulating layer
6: Control substrate
7, 22: Resin layer
8: Power source substrate
10, 10a, $10_1$, $10_2$, ..., $10_n$: Substrate
12: Buffer layer
14, $14_1$, $14_2$, ..., $14_n$: Lower electrode
16, $16_1$, $16_2$, ..., $16_n$: Dielectric layer
18, $18_1$, $18_2$, ..., $18_n$: Upper electrode
20, 20a, Cu, Cv, Cw: Capacitor element
$20_1$, $20_2$, ..., $20_n$, $C_0$, $C_1$, $C_2$, ..., $C_n$, $C_{11}$, $C_{12}$, ..., $C_{1n}$, $C_{21}$, $C_{22}$, ..., $C_{2n}$, $C_{31}$, $C_{32}$, ..., $C_3$: Element capacitor (capacitor)
24: Aperture
26, $26_1$, $26_2$, ..., $26_n$: Separator
28, 32: Ni layer
30, 34: Ag layer
36: Core rod
46: Storage battery (E)
48: Converter
50: Gate drive unit
52: Power module unit
54: Three-phase motor unit
60: Cutting tool (tap screw)
70: Vacuum chamber
72: Film-forming material supplying target
74: Film formation area
76: Tension roller
78: Material supply roller
80: Material winding roller
100: Substrate material
P: Positive electrode (plus) terminal
N: Negative electrode (minus) terminal
Q, Q1-Q6: Semiconductor chip (SiC MOSFET, semiconductor chip)
D1-D6, DI: Diode
DT: Drain terminal
ST: Source terminal
POWL, GNDL, UL, VL, WL: Connection wiring (bus bar) electrode
U, V, W: Output terminal
G, G1-G6: Gate signal terminal
SS, SS1-SS6: Source sense terminal
CS, CS1-CS6: Current sense terminal
A: Anode electrode
K: Cathode electrode

**Claims**

1. A multilayered structure comprising:

   a substrate;
   a buffer layer disposed on the substrate;
   a lower electrode disposed on the buffer layer; and
   a dielectric layer disposed on the lower electrode, the dielectric layer composed of nitrides.

2. The multilayered structure according to claim 1, wherein
   the dielectric layer comprises amorphous.

3. The multilayered structure according to claim 1 or 2, wherein
   the buffer layer comprises an amorphous conductor.

4. The multilayered structure according to any one of claims 1-3, wherein
   the buffer layer comprises one selected from the group consisting of TiAlN, IrTa, and CuTa.

5. The multilayered structure according to any one of claims 1-4, wherein
   the dielectric layer includes nitrogen, and further includes at least one kind of boron, carbon, aluminum, and silicon.

6. The multilayered structure according to any one of claims 1-4, wherein
   the dielectric layer comprises one selected from the group consisting of BN, BCN, CN, BAlN, BSiN, AlN, and SiN.

7. The multilayered structure according to any one of claims 1-6, wherein
   the substrate comprises metallic foil.

8. The multilayered structure according to any one of claims 1-6, wherein
   the substrate comprises a semiconductor substrate.

9. The multilayered structure according to claim 8, further comprising
   an insulating layer disposed on the semiconductor substrate, wherein
   the buffer layer is disposed on the insulating layer.

10. The multilayered structure according to claim 3, wherein
    the buffer layer is composed of combination of a 3d transition metal and a refractory metal.

11. The multilayered structure according to claim 10, wherein
    the buffer layer is composed of CuTa.

12. The multilayered structure according to claim 3, wherein
    the buffer layer is composed of combination of a 3d transition metal and a noble metal.

13. The multilayered structure according to claim 12, wherein
    the buffer layer is composed of any one of NiAg, TiAg, NiPt or NiIr.

14. The multilayered structure according to claim 3, wherein
    the buffer layer is composed of combination of a noble metal and a refractory metal.

15. The multilayered structure according to claim 14, wherein
    the buffer layer is composed of IrTa or PtTa.

16. The multilayered structure according to claim 3, wherein
    the buffer layer is composed of combination of a refractory metal and a semimetal.

17. The multilayered structure according to claim 16, wherein
    the buffer layer is composed of any one of TaSi, TaAl, WSi, MoSi or NbB.

**18.** The multilayered structure according to claim 3, wherein
the buffer layer is composed of combination of a 3d transition metal, a semimetal, and a nonmetal.

**19.** The multilayered structure according to claim 18, wherein
the buffer layer is composed of any one of TiAlN, TiAlB, TiSiB, NiAlN, NiAlB or NiSiB.

**20.** The multilayered structure according to claim 3, wherein
the buffer layer is composed of combination of a refractory metal, a semimetal, and a nonmetal.

**21.** The multilayered structure according to claim 20, wherein
the buffer layer is composed of TaSiN or TaAlN.

**22.** The multilayered structure according to claim 7, wherein
the metallic foil composed of any one of or any laminated structure of Ti, Ni, Cu, Mo, Al, Nb, Ta, Ag, Zr, Au, Pt, W, Ir, V, stainless-steel, 42Alloy, nickel silver, and brass.

**23.** The multilayered structure according to any one of claims 1-22, wherein
the lower electrode is composed of any one of or any laminated structure of: a single metal composed of Cr, Mo, Al, Ta, Cu, Ti, Ni, W, or Ag; an alloy composed of CuTa or TiW; nitride composed of $Ta_2N$ or TiN; a silicide composed of $WSi_2$ or TiSi; or a boride composed of TaB.

**24.** The multilayered structure according to any one of claims 1-23 further comprising
an upper electrode disposed on the dielectric layer.

**25.** The multilayered structure according to claim 24, wherein
the upper electrode is composed of any one of or any laminated structure of: a single metal composed of Cr, Mo, Al, Ta, Cu, Ti, Ni, W, or Ag; an alloy composed of CuTa or TiW; nitride composed of $Ta_2N$ or TiN; a silicide composed of $WSi_2$ or TiSi; or a boride composed of TaB.

**26.** A multilayered structure comprising a plurality of the multilayered structures according to any one of claims 1-25 configured to be laminated.

**27.** A capacitor element comprising:

the multilayered structure according to claim 24 or 25;
a first terminal electrode connected to the lower electrode, and
a second terminal electrode connected to the upper electrode.

**28.** The capacitor element according to claim 27, wherein
a plurality of the capacitor elements are comprised therein, and the plurality of the capacitor elements are laminated to be mutually connected in series so that separators are respectively inserted therebetween.

**29.** The capacitor element according to claim 27, wherein
a plurality of the capacitor elements are comprised therein, and the plurality of the capacitor elements are mutually connected in parallel.

**30.** The capacitor element according to claim 28, wherein the capacitor elements connected in series are further connected in parallel.

**31.** A capacitor element comprising:

a first capacitor element and a second capacitor element each composed of the capacitor element according to claim 27; and
a core rod for winding up the first capacitor element and the second capacitor element, wherein
the upper electrode of the first element capacitor and the upper electrode of the second element capacitor are bonded to each other, and then the bonded first and second element capacitor are wound up on the core rod in order to form the capacitor element.

**32.** A fabrication method of a capacitor element, the method comprising:

> pre-processing a substrate;
> forming a buffer layer on the substrate;
> forming a lower electrode on the buffer layer;
> forming a dielectric layer on the lower electrode, the dielectric layer composed of nitrides; and
> forming an upper electrode on the dielectric layer.

**33.** The fabrication method of the capacitor element according to claim 32, wherein
the substrate comprises metallic foil.

**34.** The fabrication method of the capacitor element according to claim 32, wherein
the substrate comprises a semiconductor substrate.

**35.** The fabrication method of the capacitor element according to claim 34 further comprising
forming an insulating layer on the semiconductor substrate, wherein
the buffer layer is formed on the insulating layer.

**36.** The fabrication method of the capacitor element according to any one of claims 32-35, wherein
each of forming the buffer layer, forming the lower electrode, forming the dielectric layer, and forming the upper
electrode is implemented by a sputtering process.

**37.** The fabrication method of the capacitor element according to claim 36, wherein each sputtering process is implemented in the same chamber.

**38.** The fabrication method of the capacitor element according to claim 36 or 37, wherein the sputtering process is
implemented by a roll-to-roll process.

**39.** The fabrication method of a capacitor element according to any one of claims 33-38 further comprising an assembly
process of laminating a plurality of the capacitor elements on another so that separators are respectively inserted
therebetween.

**40.** A cutting tool comprising the multilayered structure according to claim 1.

**41.** The cutting tool according to claim 40, wherein
the dielectric layer comprises amorphous.

**42.** The cutting tool according to claim 40 or 41, wherein
the buffer layer comprises an amorphous conductor.

**43.** The cutting tool according to any one of claims 40-42, wherein
the buffer layer comprises TiAlN, IrTa, or CuTa.

**44.** The cutting tool according to any one of claims 40-43, wherein
the dielectric layer includes a nitrogen, and includes at least one kind of boron, carbon, aluminum, or silicon.

**45.** The cutting tool according to any one of claims 40-43, wherein
the dielectric layer comprises any one of BN, BCN, CN, BAlN, BSiN, AlN or SiN.

**46.** An inverter equipment comprising the capacitor element according any of claims 27-31, wherein
the capacitor element is mounted on the inverter equipment.

**47.** The inverter equipment according to claim 46 further comprising:

> a plurality of power module semiconductor devices disposed in parallel;
> a control substrate disposed on the power module semiconductor device, the control substrate configured to
> control the power module semiconductor devices; and
> a power source substrate disposed on the power module semiconductor device, the power source substrate configured to supply a power source to the power module semiconductor devices and the control substrate, wherein
the capacitor element is disposed on the plurality of the power module semiconductor device disposed in parallel.

**48.** A capacitor fabricating apparatus comprising:

a material supply roller;
a material winding roller;
a plurality of tension rollers;
a material transferred via the tension roller between the material supply roller and the material winding roller; and
a vacuum chamber configured to supply a target material by sputtering from film-forming material supplying target in a film formation area on the material, wherein
the sputtering process of film formation for a plurality of layers in the film formation area can be implemented with the roll-to-roll process in the vacuum chamber.

FIG. 1

N

P

20

18

16

14

12

10

FIG. 2

N

P

20a

18

16

14

12

5

10a

3

FIG. 3

FIG. 4

FIG. 5

FIG. 6

FIG. 7

FIG. 8

FIG. 9

10(Al)

20.0kV X1.00K 30.0μm

# FIG. 10

(a)

(b)

(c)

FIG. 11

FIG. 12

## FIG. 13

## FIG. 14

FIG. 15

FIG. 16

FIG. 17

(a)

(b)

## FIG. 18

(a)

(b)

(c)

(d)

FIG. 19

(a)

(b)

(c)

# FIG. 20

(a)

(b)

FIG. 21

FIG. 22

(a)　　　　　(b)　　　　　(c)

# FIG. 23

(a)

(b)

(c)

FIG. 24

EP 2 955 733 A1

# FIG. 25

FIG. 26

2

FIG. 27

2

FIG. 28

FIG. 29

FIG. 30

EP 2 955 733 A1

FIG. 31

# FIG. 32

FIG. 33

## FIG. 34

## FIG. 35

# FIG. 36

(a)

LARGE AMPLITUDE

VOLTAGE

TIME

(b)

SMALL AMPLITUDE

VOLTAGE

TIME

# FIG. 37

(a)

~60

(b)

60

~16
~14
~12
~100

**INTERNATIONAL SEARCH REPORT**

| International application No. |
| --- |
| PCT/JP2014/052748 |

A. CLASSIFICATION OF SUBJECT MATTER
*H01G4/33*(2006.01)i, *C23C14/56*(2006.01)i

According to International Patent Classification (IPC) or to both national classification and IPC

B. FIELDS SEARCHED

Minimum documentation searched (classification system followed by classification symbols)
H01G4/33, C23C14/56

Documentation searched other than minimum documentation to the extent that such documents are included in the fields searched
Jitsuyo Shinan Koho          1922–1996     Jitsuyo Shinan Toroku Koho     1996–2014
Kokai Jitsuyo Shinan Koho     1971–2014     Toroku Jitsuyo Shinan Koho     1994–2014

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 2006-222396 A (TDK Corp.), | 1-2,5-9, |
|   | 24 August 2006 (24.08.2006), | 22-39,46-48 |
| A | entire text; all drawings | 3-4,10-21 |
|   | & US 2006/0180842 A1     & EP 1691383 A1 | |
|   | | |
| X | JP 2010-103459 A (Alps Electric Co., Ltd.), | 1,5-6,8-10, |
|   | 06 May 2010 (06.05.2010), | 24,26 |
| A | claims; abstract; paragraphs [0026] to [0033], | 2-4,7,11-23, |
|   | [0045] to [0047]; samples 10, 14; fig. 4 | 25 |
|   | (Family: none) | |
|   | | |
| X | JP 2001-24167 A (Hitachi, Ltd.), | 1,3,5-9,22, |
|   | 26 January 2001 (26.01.2001), | 24-39,46-48 |
|   | abstract; claims; paragraphs [0015] to [0033]; | |
|   | fig. 1 | |
|   | (Family: none) | |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 26 February, 2014 (26.02.14) | 20 May, 2014 (20.05.14) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

45

**INTERNATIONAL SEARCH REPORT**

| | International application No. |
|---|---|
| | PCT/JP2014/052748 |

C (Continuation). DOCUMENTS CONSIDERED TO BE RELEVANT

| Category* | Citation of document, with indication, where appropriate, of the relevant passages | Relevant to claim No. |
|---|---|---|
| X | JP 2010-142932 A (Sumitomo Electric Industries, Ltd.), 01 July 2010 (01.07.2010), abstract; paragraph [0013] (Family: none) | 40-45 |
| Y | JP 2007-107023 A (Oki Electric Industry Co., Ltd.), 26 April 2007 (26.04.2007), paragraphs [0095] to [0110]; fig. 4 & US 2007/0080388 A1 & US 2009/0011593 A1 | 1,3-6,8-9, 18-19,23-39, 46-48 |
| Y | JP 2008-270259 A (Matsushita Electric Industrial Co., Ltd.), 06 November 2008 (06.11.2008), paragraph [0054] & US 2008/0251816 A1 | 1,3-6,8-9, 18-19,23-39, 46-48 |

Form PCT/ISA/210 (continuation of second sheet) (July 2009)

## INTERNATIONAL SEARCH REPORT

| International application No. |
|---|
| PCT/JP2014/052748 |

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
Claim 1 and Claims 40-45 possess a common technical feature of "a multilayer structure body, comprising a substrate, a buffer layer which is positioned upon the substrate, a lower electrode which is positioned upon the buffer layer, and a dielectric layer which is positioned upon the lower electrode and which is formed from a nitride" (hereinafter "known and established art X"). In view of the contents of the disclosures recited in the cited references 1-3 (JP 2006-222396 A, JP 2010-103459 A, JP 2001-24167 A), however, the said technical feature does not contribute to the prior art, and thus, the said technical feature is not found to be a special technical feature.
(Continued on attached sheet)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**
☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

International application No.

PCT/JP2014/052748

<u>Continuation of Box No.III of continuation of first sheet(2)</u>

In addition, nor is there any other common or corresponding special technical feature present between these inventions.
Thus, the claims are classified into the following two inventions having the following respective special technical features:

(Invention 1) Claims 1-39 and 46-48:
A multilayer structure, a capacitor, or a module comprising a capacitor, having a structure of the known and established art X; and

(Invention 2) Claims 40-45:
A cutting tool having the structure of the known and established art X.

Claims 40-45 do not constitute an invention of the same category as the invention according to Claim 1, which includes all specific features of the invention according to Claim 1. Thus, as a result of carrying out a search on the claims classified as Invention 1, it is found that Claims 40-45 do not constitute an invention for which it would be possible to carry out a search without substantially requiring an additional prior art search and/or determination, and moreover, it is also found that no other circumstance applies whereby it would be efficient to carry out a search on Claims 40-45 together with Claims 1-39 and 46-48, and therefore, it is not possible to classify Claims 40-45 into Invention 1.

Whereas the invention according to Claims 40-45 encompasses all that has the desired features of "a multilayer structure body, comprising a substrate, a buffer layer which is positioned upon the substrate, a lower electrode which is positioned upon the buffer layer, and a dielectric layer which is positioned upon the lower electrode and which is formed from a nitride", what is disclosed pursuant to the meaning of Article 5 of the PCT is only the forming of the dielectric layer from a material such as AlN or BN which are known to be super-hard materials. Nor is there any recitation therein of how the substrate, the buffer layer, or the lower electrode are employed in the multilayer structure body, and thus, support is lacking pursuant to the meaning of Article 6 of the PCT. Accordingly, the present search was carried out upon the disclosed scope which is supported in the specification, or in other words, upon a cutting tool having a multilayer structure, and whereupon a material such as AlN or BN, which are known to be super-hard materials, is employed in a stacked structure, the particulars of which are recited in the specification.

Form PCT/ISA/210 (extra sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6570753 B
- US 6939775 B
- JP H06267783 B